(19)

**Europäisches Patentamt**
**European Patent Office**
**Office européen des brevets**

(11) **EP 4 290 247 B1**

(12) **EUROPEAN PATENT SPECIFICATION**

(45) Date of publication and mention
of the grant of the patent:
**14.05.2025 Bulletin 2025/20**

(21) Application number: **22178310.3**

(22) Date of filing: **10.06.2022**

(51) International Patent Classification (IPC):
***G01R 22/10*** *(2006.01)*

(52) Cooperative Patent Classification (CPC):
**G01R 22/10**

(54) **ELECTRICITY METER WITH AN IMPEDANCE LEARNING ALGORITHM**

ELEKTRIZITÄTSZÄHLER MIT IMPEDANZLERNENDEM ALGORITHMUS

COMPTEUR D'ÉLECTRICITÉ DOTÉ D'UN ALGORITHME D'APPRENTISSAGE D'IMPÉDANCE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**13.12.2023 Bulletin 2023/50**

(73) Proprietor: **Kamstrup A/S
8660 Skanderborg (DK)**

(72) Inventor: **Kirkegaard, Dennis
8850 Bjerringbro (DK)**

(74) Representative: **Patentanwälte Hemmer Lindfeld
Frese
Partnerschaft mbB
Wallstraße 33a
23560 Lübeck (DE)**

(56) References cited:
**WO-A1-2018/122160**

• SERGEY IAKOVLEV ET AL: "Low-Voltage
Distribution Network Impedances Identification
Based on Smart Meter Data", ARXIV.ORG,
CORNELL UNIVERSITY LIBRARY, 201 OLIN
LIBRARY CORNELL UNIVERSITY ITHACA, NY
14853, 18 September 2018 (2018-09-18),
XP081192552
• HOSSEINI ZOHREH S ET AL: "Machine Learning-
Enabled Distribution Network Phase
Identification", IEEE TRANSACTIONS ON
POWER SYSTEMS, IEEE, USA, vol. 36, no. 2, 22
July 2020 (2020-07-22), pages 842 - 850,
XP011839326, ISSN: 0885-8950, [retrieved on
20210218], DOI: 10.1109/TPWRS.2020.3011133
• THERRIEN FRANCIS ET AL: "Assessment of
Measurement-Based Phase Identification
Methods", IEEE OPEN ACCESS JOURNAL OF
POWER AND ENERGY, IEEE, vol. 8, 22 March
2021 (2021-03-22), pages 128 - 137, XP011846957,
DOI: 10.1109/OAJPE.2021.3067632

**Description**

TECHNICAL FIELD

The present disclosure is directed to the field of using electricity meters, predominantly used to determine electricity consumption in an electricity distribution network for billing purposes, for determining impedance values of electricity distribution network.

BACKGROUND

Operators of electricity distribution networks have a high interest in having up-to-date information about the impedances in their electricity distribution network. For example, a customer of the operator may request an installation of a solar power facility for feeding electric power into the electricity distribution network and/or an installation of a wall box for drawing electric power from the electricity distribution network with high consumption peaks for charging electric car batteries. The local impedance of the electricity distribution network near the customer must allow such an installation. If the impedance there is too high, the electricity distribution network will break down when the expected high peak currents occur. In particular, the last section of the electricity distribution network between the lowest-voltage level transformer station to the consumer may be a bottle-neck and the weakest part of the electricity distribution network in this respect.

Geographic information system (GIS) data may be used by operators to estimate the distance between an electricity consumer and the lowest-voltage level transformer station in order to roughly estimate the relevant impedance of the electricity distribution network for that consumer. However, such an estimation is often wrong, because it lacks information about the wire size, connector quality or other relevant factors that have an influence on the true impedance of the electricity distribution network.

It is known that electricity meters, predominantly used to determine electricity consumption in an electricity distribution network for billing purposes, may be used to determine impedance values. For example, WO 2018/122160 A1 describes an electricity meter with an impedance learning algorithm. The meter-based impedance learning algorithm (MILA) described therein determines zero sequence impedance values and negative sequence impedance values. The operator of an electricity distribution network equipped with such electricity meters is able to determine up-to-date impedance values.

However, the MILA described in WO 2018/122160 A1 does not allow for determining individual impedances for each phase of the electricity distribution network. Knowing the individual impedances for each phase of the electricity distribution network would be, however, of great value for an operator, because it allows to determine unbalances between the phases and which phase of the electricity distribution network may have a too high impedance.

It is therefore a problem of the present disclosure to determine individual impedances for each phase of the electricity distribution network by means of electricity meters that are predominantly used to determine electricity consumption in an electricity distribution network for billing purposes.

SUMMARY

The electricity meter, the metering system and the method according to the independent claims provide a solution to this problem.

According to a first aspect of the present disclosure, an electricity meter is provided for determining electricity consumption in a three-phase electricity distribution network, wherein the electricity meter comprises:

- a circuit for determining a voltage $V_a$, $V_b$, $V_c$ and a current $I_a$, $I_b$, $I_c$ at each phase of the electricity distribution network, wherein the voltage $V_a$, $V_b$, $V_c$ and the current $I_a$, $I_b$, $I_c$ are preferably complex numbers,
- at least one microcontroller for calculating electricity consumption from the electricity distribution network, and
- an impedance learning algorithm for being executed by the at least one microcontroller, wherein the impedance learning algorithm is configured to determine, based on a plurality of changes in the determined voltage $\Delta V_a$, $\Delta V_b$, $\Delta V_c$ and current $\Delta I_a$, $\Delta I_b$, $\Delta I_c$ at each phase of the electricity distribution network, a zero sequence impedance $Z_0$ and a negative sequence impedance $Z_2$ of the electricity distribution network,

characterised in that
the impedance learning algorithm is configured to determine an impedance value $Z_a$, $Z_b$, $Z_c$ for each phase of the electricity distribution network by determining correlation terms $z_{20}$, $z_{02}$, wherein the correlation term $z_{20}$ is indicative of a correlation between a zero sequence voltage $V_0$ and a negative sequence current $I_2$, and wherein the correlation term $z_{02}$ is indicative of a correlation between a zero sequence current $I_0$ and a negative sequence voltage $V_2$.

Compared to the MILA known from WO 2018/122160 A1, the present disclosure provides for an <u>advanced</u> meter-

based impedance learning algorithm (A-MILA), because it allows determining individual impedances for each phase of the electricity distribution network.

Electrical impedance is the measure of the complex ratio of the voltage to the current in an alternating current (AC) circuit. The impedance therefore has two orthogonal vectors, where resistance forms the real part of complex impedance and reactance forms the imaginary part of complex impedance.

The electricity distribution network comprises a plurality of consumers, power sources, distribution lines, and transformer stations, all of which may change over time. The impedance of the electricity distribution network as seen from each electricity meter may therefore change over time, in particular when the configuration of the electricity distribution network changes. In a simplified model, the impedance is defined by the resistance and reactance between the meter and the source, i.e. a generator, and the impedance seen at the electricity meter is the impedance between the electricity meter and the power source. However, in reality, every single component of the electrical distribution network contributes to the impedance thus affecting the impedance seen by the electricity meter. Therefore, the impedance values determined by the A-MILA is the impedance value of the electrical distribution network "as seen by the electricity meter".

In order to analyse properties of a three-phase electricity distribution network, it is useful to apply a concept of symmetrical components (first developed by Fortescue in 1918). The general concept of symmetrical components is that an unbalanced system of n related phasors can be resolved into n systems of balanced phasors called "symmetrical components" of the original phasors. In a three-phase electricity distribution network, a set of three unbalanced phasors can be resolved into three balanced systems of phasors as follows:

a) Positive sequence components consisting of a balanced system of three phasors having the same phase sequence as the original phasors;

b) Negative sequence components consisting of a balanced system of three phasors having a phase sequence opposite to that of the original phasors; and

c) Zero sequence components consisting of three phasors equal in amplitude and phase.

The notation of the zero sequence components is indicated by the subfix "0" (zero), the positive sequence components are denoted herein by the subfix "1" (one), and the negative sequence components are denoted herein by the subfix "2" (two). The phase components for the respective phases a, b, c are denoted herein by subfix "a", "b" and "c", respectively. The neutral (wire) component is denoted by subfix "N".

The following relations apply:

| Positive sequence components | Negative sequence components | Zero sequence components |
|---|---|---|
| $V_{b1} = a^2 V_{a1}$ <br> $V_{c1} = a V_{a1}$ | $V_{b2} = a V_{a2}$ <br> $V_{c2} = a^2 V_{a2}$ | $V_{b0} = V_{a0}$ <br> $= V_{c0}$ |
| (denoted by subscript 1) | (denoted by subscript 2) | (denoted by subscript 0) |

The transformation between symmetrical components is performed by applying a complex size operator $a$, which denotes a 120° phase shift, wherein

$$a = e^{i\frac{2\pi}{3}} = \cos(120°) + i\sin(120°)$$
$$\approx -0.5 + i0.866$$

The operators $a^2$ and $a^3$ represent phase shifts of 240° and 360°, respectively. Thus,

$$a^2 = e^{i\frac{4\pi}{3}} = \cos(240°) + i\sin(240°)$$
$$\approx -0.5 - i0.866$$

and

$$a^3 = e^{i\frac{6\pi}{3}} = e^{i2\pi} = \cos(360°) + i\sin(360°)$$
$$= 1.0 + i0.0$$

which implies that

$$a^0 = a^3 = a^6 \dots$$

$$a = a^4 = a^7 \dots$$

$$a^2 = a^5 = a^8 \dots$$

So, the impedances in an electrical distribution network or grid may be described in symmetrical components known as the positive sequence impedance $Z_1$, the negative sequence impedance $Z_2$ and the zero sequence impedance $Z_0$. In a balanced electrical distribution network or grid, the impedances of the phases are equal. By the nature of symmetrical components, the positive-, negative- and zero sequences do not affect each other in a balanced grid and could be estimated independently. At the same time, the positive and negative sequence impedances in transformers and distribution systems are equals. By this, it is possible to equate the positive sequence impedance with the negative sequence impedance. The MILA known from the prior art makes the simplified assumption of a balanced grid, wherein the impedances of the phases are considered to be equal.

This assumption is given up for the A-MILA described herein. Thus, in order to determine the individual impedances $Z_a, Z_b, Z_c, Z_N$ of the three phases a, b, c and the neutral wire N, the zero-sequence impedance $Z_0$, the negative-sequence impedance $Z_2$, and the correlation terms $z_{02}$, $z_{20}$ are determined. This is done based on voltage changes $\Delta V_a$, $\Delta V_b$, $\Delta V_c$ and current changes $\Delta I_a$, $\Delta I_b$, $\Delta I_c$ detemined by the electricity meter at each phase of the electricity distribution network.

Changes in the zero sequence voltage $\Delta V_0$ and the negative sequence voltage $\Delta V_2$ as well as changes in the zero sequence current $\Delta I_0$ and the negative sequence current $\Delta I_2$ can be determined using the following equations:

$$\Delta V_{02} = \begin{bmatrix} \Delta V_0 \\ \Delta V_2 \end{bmatrix} = \frac{1}{3} \begin{bmatrix} 1 & 1 & 1 \\ 1 & a^2 & a \end{bmatrix} \begin{bmatrix} \Delta V_a \\ \Delta V_b \\ \Delta V_c \end{bmatrix}$$

$$\Delta I_{02} = \begin{bmatrix} \Delta I_0 \\ \Delta I_2 \end{bmatrix} = \frac{1}{3} \begin{bmatrix} 1 & 1 & 1 \\ 1 & a^2 & a \end{bmatrix} \begin{bmatrix} \Delta I_a \\ \Delta I_b \\ \Delta I_c \end{bmatrix}$$

The impedance matrix $Z_{02}$ relates $\Delta V_{02}$ to $\Delta I_{02}$ by:

$$-\Delta V_{02} \propto Z_{02} \Delta I_{02}$$

$$-\begin{bmatrix} \Delta V_0 \\ \Delta V_2 \end{bmatrix} \propto \begin{bmatrix} Z_0 & z_{20} \\ z_{02} & Z_2 \end{bmatrix} \begin{bmatrix} \Delta I_0 \\ \Delta I_2 \end{bmatrix}$$

$$\begin{bmatrix} \left( V_{0_{t_0}} - V_{0_{t_1}} \right) \\ \left( V_{2_{t_0}} - V_{2_{t_1}} \right) \end{bmatrix} \propto \begin{bmatrix} Z_0 & z_{20} \\ z_{02} & Z_2 \end{bmatrix} \begin{bmatrix} \left( I_{0_{t_1}} - I_{0_{t_0}} \right) \\ \left( I_{2_{t_1}} - I_{2_{t_0}} \right) \end{bmatrix}$$

wherein the changes in voltage and current are determined between a first point in time $t_0$ and a second point in time $t_1$.

Thus, the correlation term $z_{20}$ is indicative of a correlation between the zero sequence voltage $V_0$ and the negative sequence current $I_2$, and the correlation term $z_{02}$ is indicative of a correlation between the zero sequence current $I_0$ and the negative sequence voltage $V_2$.

Optionally, the impedance learning algorithm may be configured to include, for the determination of the zero sequence impedance $Z_0$ and the negative sequence impedance $Z_2$ as well as the correlation terms $z_{20}$, $z_{02}$, only those

changes in the determined voltage $\Delta V_a$, $\Delta V_b$, $\Delta V_c$ and current $\Delta I_a$, $\Delta I_b$, $\Delta I_c$ for which the relative change in current $\Delta I_a/I_a$, $\Delta I_b/I_b$, $\Delta I_c/I_c$ is a factor $k > 1$, preferably $k \gg 1$, larger than the relative change in voltage $\Delta V_a/V_a$, $\Delta V_b/V_b$, $\Delta V_c/V_c$. The reason for this is that the supply voltage at the closest transformer station in the electricity distribution network may vary. Furthermore, the supply voltage may vary depending on the power consumption of other consumers in the electricity distribution network. Such variations in the supply voltage must not be misinterpreted as a change of impedance. It is possible to set up an expression like

$$V = E - ZI + v,$$

wherein V is the voltage determined by the electricity meter, $I$ is the current determined by the electricity meter, $E$ is the electro motoric force (EMF) provided by the closest transformer station, $Z$ is the impedance and v is a noise component, e.g. due to fluctuations induced by other consumers in the electricity distribution network. In general, the electricity meter does not know the EMF in the closest transformer station nor the noise component. However, it can be assumed that the EMF is relatively static and varies only slowly over time. By making a differentiation over time assuming a constant impedance, the equation

$$\Delta V = \Delta E - Z\Delta I + \Delta v$$

follows. If the time interval for determining the changes in voltage and current is small, however not infinitesimally small, it can be assumed that the change in EMF is close to zero. The above expression can be rearranged to

$$-\frac{\Delta V}{\Delta I} = Z - \sigma$$

wherein the noise component

$$\sigma = \frac{\Delta E}{\Delta I} + \frac{\Delta v}{\Delta I}$$

can be assumed to be stochastic within a small time interval, e.g. 10 seconds. In order to exclude cases in which a change in EMF, i.e. $\Delta E$, is the main cause to changes in the voltage seen by the electricity meter, it is advantageous to make sure that a determined change in the voltage is due to a change in the load rather than a change in the EMF. As large changes in EMF mainly show up in the positive sequence voltage $V_1$, it is beneficial to consider negative sequence components $V_2$, $I_2$ and to neglect positive sequence components $V_1$, $I_1$. Nevertheless, EMF-induced voltage changes also affect the negative sequence components $V_2$, $I_2$. It is known that EMF-induced voltage changes correlate with changes in the current, i.e.

$$\frac{\Delta V}{V} \approx \frac{\Delta I}{I}$$

So, it is beneficial to include only those changes of voltage and current, for which the relative change in current is significantly higher than the relative change in voltage; or vice versa, only when the relative voltage change is insignificant compared to the relative current change:

$$\frac{\Delta V}{V} \ll \frac{\Delta I}{I}$$

or

$$k\frac{\Delta V}{V} < \frac{\Delta I}{I}$$

wherein

$$k > 1, \text{ preferably } k \gg 1.$$

By rearranging to

$$k \frac{\Delta V}{\Delta I} < \frac{V}{I}$$

it is easier to see under which condition the assumption about uncorrelated or insignificant EMF is true. This also helps to avoid that the stochastic noise component $\sigma$ takes infinite or large values, because it rejects too small changes of current into the calculation. The constant $k$ may be determined empirically, wherein $k = 10$ may be an adequate value to start with. So, the impedance may be estimated as follows

$$-\frac{\Delta V}{\Delta I} = Z - \sigma \quad \text{if} \quad k \frac{\Delta V}{\Delta I} < \left. \frac{V_{RMS}}{I_{RMS}} \right|_{k \gg 1}$$

wherein the factor $V_{RMS}/I_{RMS}$ may be referred to as a load factor with the unit Ohm, wherein the subscript RMS denotes a root-mean-squared value.

In a first example, the voltage may be 230V and the current may be 10A. If the current changes to 11A causing a voltage drop to 229V, this gives

$$-\frac{\Delta V}{\Delta I} = -\frac{229V - 230V}{11A - 10A} = \frac{1V}{1A} = 1\Omega \quad \text{if} \quad 10 \cdot 1\Omega < \frac{230V}{10A} = 23\Omega \rightarrow \text{true}$$

In a second example, the voltage may be 230V and the current may be 23A. If the voltage changes to 240V causing the current to increase to 24A, this gives

$$-\frac{\Delta V}{\Delta I} = -\frac{240V - 230V}{24A - 23A} = \frac{-10V}{1A} = -10\Omega \quad \text{if} \quad 10 \cdot 10\Omega < \frac{230V}{23A} = 10\Omega \rightarrow \text{false}$$

So, the impedance would be not be estimated in this case.

The adequate choice of the factor k, preferably $k \gg 1$, is a compromise between effectively filtering out changes in voltage/current for making more reliable estimations of the impedance and not rejecting too many changes in voltage/-current that are due to a change in impedance.

Optionally, following the above the derivation, the impedance learning algorithm may be configured to determine the correlation terms $z_{20}$, $z_{02}$ as follows:

$$z_{20} = -\frac{\Delta V_0}{\Delta I_2} - Z_0 \frac{\Delta I_0}{\Delta I_2} = -\frac{\Delta V_a + \Delta V_b + \Delta V_c}{\Delta I_a + a^2 \Delta I_b + a \Delta I_c} - Z_0 \frac{\Delta I_a + \Delta I_b + \Delta I_c}{\Delta I_a + a^2 \Delta I_b + a \Delta I_c},$$

$$z_{02} = -\frac{\Delta V_2}{\Delta I_0} - Z_2 \frac{\Delta I_2}{\Delta I_0} = -\frac{\Delta V_a + a^2 \Delta V_b + a \Delta V_c}{\Delta I_a + \Delta I_b + \Delta I_c} - Z_2 \frac{\Delta I_a + a^2 \Delta I_b + a \Delta I_c}{\Delta I_a + \Delta I_b + \Delta I_c},$$

wherein $a = e^{i\frac{2\pi}{3}}$ is a complex operator to account for a nominal 120° phase shift between the phases.

Optionally, following the above derivation, the impedance learning algorithm may be configured to determine individually the impedance value $Z_a$, $Z_b$, $Z_c$ for each phase of the electricity distribution network and an impedance value $Z_N$ for the neutral wire of the electricity distribution network as follows:

$$Z_a = Z_2 + z_{20} + z_{02},$$

$$Z_b = Z_2 + a^2 z_{20} + a z_{02},$$

$$Z_c = Z_2 + a z_{20} + a^2 z_{02},$$

and

$$Z_N = \tfrac{1}{3}(Z_0 - Z_2).$$

Optionally, the impedance learning algorithm may be configured to determine the changes in the voltage $\Delta V_a$, $\Delta V_b$, $\Delta V_c$ and current $\Delta I_a$, $\Delta I_b$, $\Delta I_c$ based on the voltage $V_a$, $V_b$, $V_c$ and current $I_a$, $I_b$, $I_c$ determined at different points in time $t_0$ and $t_1$, wherein the difference between $t_0$ and $t_1$ is below five minutes. As explained before, it is beneficial to observe the changes in voltage and current within a sufficiently small time window, in which EMF changes are unlikely to occur. The time interval $[t_1\text{-}t_0]$ may, however, be chosen large enough to determine changes in voltage and current well above a noise level, e.g. the difference between $t_0$ and $t_1$ may be above one second. Most preferably, the time interval may fulfil $5s \leq t_1 \text{-} t_0 \leq 30s$.

Optionally, the impedance learning algorithm may be configured to include, for the determination of the zero sequence impedance $Z_0$ and the negative sequence impedance $Z_2$ as well as the correlation terms $z_{20}$, $z_{02}$, only those changes in the voltage $\Delta V_a$, $\Delta V_b$, $\Delta V_c$ and current $\Delta I_a$, $\Delta I_b$, $\Delta I_c$ for which the determined voltage $V_a$, $V_b$, $V_c$ is above a minimum voltage threshold $V_{min}$ or the determined current $I_a$, $I_b$, $I_c$ is above a minimum current threshold $I_{min}$.

Optionally, the impedance learning algorithm may be configured to iteratively optimise the determined impedance value $Z_a$, $Z_b$, $Z_c$ for each phase of the electricity distribution network and an impedance value $Z_N$ for a neutral wire of the electricity distribution network.

Optionally, the impedance learning algorithm may be configured to log, after having determined the impedance value $Z_a$, $Z_b$, $Z_c$ for each phase and an impedance value $Z_N$ for a neutral wire of the electricity distribution network, an accumulated change of current $\Delta I_{a_\Sigma}$, $\Delta I_{b_\Sigma}$, $\Delta I_{c_\Sigma}$ indicative of an accumulated sum of previously determined changes in the current $\Delta I_a$, $\Delta I_b$, $\Delta I_c$. For example, the accumulated change of phase currents $\Delta I_{a_\Sigma}$, $\Delta I_{b_\Sigma}$, $\Delta I_{c_\Sigma}$ may be determined by the electricity meter for the respective line as

$$\Delta I_{a_\Sigma} = \sum_n \left( \frac{\sqrt{P_{at_1 n}^2 + Q_{at_1 n}^2}}{V_{a_{t_1} n}} - \frac{\sqrt{P_{at_0 n}^2 + Q_{at_0 n}^2}}{V_{a_{t_0} n}} \right)$$

$$\Delta I_{b_\Sigma} = \sum_n \left( \frac{\sqrt{P_{bt_1 n}^2 + Q_{bt_1 n}^2}}{V_{b_{t_1} n}} - \frac{\sqrt{P_{bt_0 n}^2 + Q_{bt_0 n}^2}}{V_{b_{t_0} n}} \right)$$

$$\Delta I_{c_\Sigma} = \sum_n \left( \frac{\sqrt{P_{ct_1 n}^2 + Q_{ct_1 n}^2}}{V_{c_{t_1} n}} - \frac{\sqrt{P_{ct_0 n}^2 + Q_{ct_0 n}^2}}{V_{c_{t_0} n}} \right)$$

wherein n denotes the number of conducted optimisation runs of the determined phase impedances, P is the active power and Q is the reactive power on the respective phase a, b, c at the respective point in time $t_0$, $t_1$.

According to a second aspect of the present disclosure, a method is provided for determining impedance values in a three-phase electricity distribution network, wherein the method comprises:

- determining a voltage $V_b$, $V_b$, $V_c$ and a current $I_a$, $I_b$, $I_c$ at each phase of the electricity distribution network by means of at least one electricity meter for determining electricity consumption in a three-phase electricity distribution network,
- calculating electricity consumption from the electricity distribution network by means of said at least one electricity meter, and
- determining by said at least one electricity meter, based on a plurality of changes in the determined voltage $\Delta V_a$, $\Delta V_b$, $\Delta V_c$ and current $\Delta I_a$, $\Delta I_b$, $\Delta I_c$ at each phase of the electricity distribution network, a zero sequence impedance $Z_0$ and a negative sequence impedance $Z_2$ of the electricity distribution network,

characterised in that
the method further comprises determining an impedance value $Z_a$, $Z_b$, $Z_c$ for each phase of the electricity distribution network by determining correlation terms $z_{20}$, $z_{02}$, wherein the correlation term $z_{20}$ is indicative of a correlation between a zero sequence voltage $V_0$ and a negative sequence current $I_2$, and wherein the correlation term $z_{02}$ is indicative of a correlation between a zero sequence current $I_0$ and a negative sequence voltage $V_2$.

Optionally, only those changes in the determined voltage $\Delta V_a$, $\Delta V_b$, $\Delta V_c$ and current $\Delta I_a$, $\Delta I_b$, $\Delta I_c$ for which the relative change in current $\Delta I_a/I_a$, $\Delta I_b/I_b$, $\Delta I_c/I_c$ is a factor $k > 1$, preferably $k \gg 1$, larger than the relative change in voltage $\Delta V_a/V_a$, $\Delta V_b/V_b$, $\Delta V_c/V_c$ may be included for the determination of the zero sequence impedance $Z_0$ and the negative sequence impedance $Z_2$ as well as the correlation terms $z_{20}$, $z_{02}$.

Optionally, the correlation terms $z_{20}$, $z_{02}$ may be determined as follows:

$$z_{20} = Z_a + aZ_b + a^2Z_c,$$

$$z_{02} = Z_a + a^2Z_b + aZ_c,$$

wherein $a = e^{i\frac{2\pi}{3}}$ is a complex operator to account for a nominal 120° phase shift between the phases.

Optionally, the impedance value $Z_a$, $Z_b$, $Z_c$ for each phase of the electricity distribution network and an impedance value $Z_N$ for a neutral wire of the electricity distribution network may be individually determined as follows:

$$Z_a = Z_2 + z_{20} + z_{02},$$

$$Z_b = Z_2 + a^2z_{20} + az_{02},$$

$$Z_c = Z_2 + az_{20} + a^2z_{02},$$

and

$$Z_N = \frac{1}{3}(Z_0 - Z_2).$$

Optionally, the changes in the voltage $\Delta V_a$, $\Delta V_b$, $\Delta V_c$ and current $\Delta I_a$, $\Delta I_b$, $\Delta I_c$ may be determined based on the voltage $V_a$, $V_b$, $V_c$ and current $I_a$, $I_b$, $I_c$ determined at different points in time $t_0$ and $t_1$, wherein the difference between $t_0$ and $t_1$ is below five minutes.

Optionally, only those changes in the voltage $\Delta V_a$, $\Delta V_b$, $\Delta V_c$ and current $\Delta I_a$, $\Delta I_b$, $\Delta I_c$ for which the determined voltage $V_a$, $V_b$, $V_c$ or the determined current $I_a$, $I_b$, $I_c$ is above a minimum threshold $V_{min}$, $I_{min}$ may be included for the determination of the zero sequence impedance $Z_0$ and the negative sequence impedance $Z_2$ as well as the correlation terms $z_{20}$, $z_{02}$.

Optionally, the determined impedance value $Z_a$, $Z_b$, $Z_c$ for each phase of the electricity distribution network and an impedance value $Z_N$ for a neutral wire of the electricity distribution network may be iteratively optimised.

According to a third aspect of the present disclosure, a system for determining electricity consumption in a three-phase electricity distribution network is provided, wherein the system comprises:

- a plurality of previously described electricity meters being installed at electricity consumer sites in the three-phase electricity distribution network, and
- a head-end system (HES) in signal-connection with the plurality of electricity meters for automatically collecting electricity consumption information from the consumer sites, wherein the head-end system (HES) is configured to collect from the electricity meters an impedance value $Z_a$, $Z_b$, $Z_c$ for each phase of the electricity distribution network.

Optionally, the head-end system (HES) may be further configured to collect from the electricity meters an impedance value $Z_N$ for a neutral wire of the electricity distribution network.

The method disclosed herein may be implemented in form of compiled or uncompiled software code that is stored on a computer readable medium with instructions for executing the method. Alternatively, or in addition, the method may be executed by software installed on a microcontroller of the electricity meter, on a cloud-based system and/or on a computer of a head-end system (HES).

SUMMARY OF THE DRAWINGS

Embodiments of the present disclosure will now be described by way of example with reference to the following figures of which:

Fig. 1 shows schematically an example of a three-phase electricity distribution network according to the present disclosure;

Fig. 2        shows phasor representations of positive sequence voltages, negative sequence voltages, and zero sequence voltages;

Fig. 3        shows schematically representation of an example of the method disclosed herein;

Fig. 4        shows schematically the steps of an example of the method disclosed herein;

Figs. 5a      shows an example of a logging table as determined and provided by an example of an electricity meter and method disclosed herein;

Figs. 5b      shows an example of a configuration table as received and processed by an example of an electricity meter disclosed herein; and

Figs. 6a-c    show schematically another example of a three-phase electricity distribution network according to the present disclosure.

DETAILED DESCRIPTION

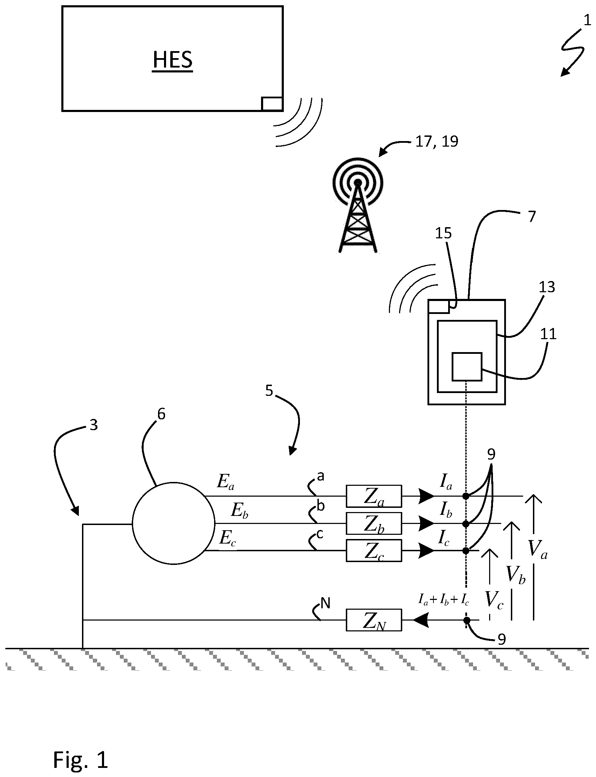

Fig. 1 shows a three-phase electricity distribution network 1 in a very simplified and schematic way. The three-phase electricity distribution network 1 provides electric energy in form of a supply AC voltage on three phase lines a, b, c. The three-phase electricity distribution network 1 further comprises a neutral wire N. The three-phase electricity distribution network 1 comprises a transmission network level 3 and a distribution network level 5. The transmission network level 3 may be operated at high transmission voltages above 60kV for efficiently transporting the electric energy from a power plant over long distances, whereas the distribution network level 5 may be operated at voltages below 60kV to connect consumer sites (not shown) to the electricity distribution network 1. A typical consumer site, e.g. household, is connected to the distribution network level 5 at a supply voltage below 10 kV; the majority of the consumer sites is in fact connected at a supply voltage below 1 kV. The transmission network level 3 and the distribution network level 5 are separated by at least one transformer station 6 transforming the high transmission voltage down to the supply voltage. There may be more than one transmission network level 3 with additional transformer stations between them, so that the voltage may be reduced in steps across the different network levels. Fig. 1 shows the transformer station 6 at the lowest network level, i.e. the transformer station 6 at the distribution network level 5, i.e. being closest to the consumer site and providing the supply voltage to the consumer site.

The transformer station 6 provides an electro-motoric force (EMF) or supply AC voltage $E_a$, $E_b$, $E_c$ via the respective phase lines a, b, c of the three-phase electricity distribution network 1 at the distribution network level 5. An electricity meter 7 is installed at a consumer site in order to determine the power consumption of said consumer site. It should be noted that a consumer site is typically located at an end point of the electricity distribution network 1, so that the electricity meter 7 is installed at an end point of the electricity distribution network 1. The electricity meter 7 comprises connection terminals 9 connected to each of the phase lines a, b, c as well as to the neutral wire N of the electricity distribution network 1. The electricity meter 7 comprises a circuit 11 for determining a voltage $V_a$, $V_b$, $V_c$ and a current $I_a$, $I_b$, $I_c$ at each phase a, b, c of the electricity distribution network 1. The phase voltages $V_a$, $V_b$, $V_c$ are determined relative to the neutral wire N at ground potential. The neutral wire N takes the sum of the phase currents $I_a$, $I_b$, $I_c$, which is zero in a perfectly balanced situation and non-zero in a non-balanced situation.

The electricity meter 7 comprises at least one microcontroller 13 for calculating electricity consumption from the electricity distribution network 1. The microcontroller 13 may comprise the circuit 11 for determining the voltages $V_a$, $V_b$, $V_c$ and the currents $I_a$, $I_b$, $I_c$. Alternatively, or in addition, the microcontroller 13 may be part of the circuit 11 or the microcontroller 13 and the circuit 11 may be separate electronic components of the electricity meter 7. Calculating electricity consumption is the primary capability of the electricity meter 7 in order to provide information about the electricity consumption for billing purposes. The electricity meter 7 may comprise a communication interface 15 for connecting preferably wirelessly, or via cable, to a communication network 17 and/or to an automatic metering infrastructure (AMI) 19 in order to provide regularly, sporadically or continuously electricity consumption data to a head-end-system HES of a utility company. The head-end-system HES receives and collects electricity consumption data from a plurality of electricity meters being installed at a plurality of distributed consumer sites.

In addition to the primary capability of calculating and providing electricity consumption data, the electricity meter 7 has a secondary capability to determine and provide impedance information data. A utility provider has a high interest in knowing impedances $Z_a, Z_b, Z_c, Z_N$ of the individual phase lines a, b, c and of the neutral wire N between the transformer station 6 and the electricity meter 7. Therefore, the electricity meter 7 comprises an impedance learning algorithm, preferably in form of software, for being executed by the microcontroller 13. The impedance learning algorithm is configured to determine, based on a plurality of changes in the determined voltage $\Delta V_a$, $\Delta V_b$, $\Delta V_c$ and current $\Delta I_a$, $\Delta I_b$, $\Delta I_c$ at each phase a, b, c of the electricity distribution network 1, a zero sequence impedance $Z_0$ and a negative sequence impedance $Z_2$ of the electricity distribution network 1.

The zero sequence impedance $Z_0$ and the negative sequence impedance $Z_2$ of the electricity distribution network 1 alone, however, are not sufficient to allow determining the impedance values $Z_a$, $Z_b$, $Z_b$, $Z_N$ for each phase a, b, c and the neutral wire N of the electricity distribution network 1. In addition to the zero sequence impedance $Z_0$ and the negative sequence impedance $Z_2$, the impedance learning algorithm is configured to determine correlation terms $z_{20}$, $z_{02}$, wherein the correlation term $z_{20}$ is indicative of a correlation between a zero sequence voltage $V_0$ and a negative sequence current $I_2$, and wherein the correlation term $z_{02}$ is indicative of a correlation between a zero sequence current $I_0$ and a negative sequence voltage $V_2$.

In the following, the determination of the impedance values $Z_a$, $Z_b$, $Z_c$, $Z_N$ for each phase a, b, c and the neutral wire N of the electricity distribution network 1 is explained in more detail.

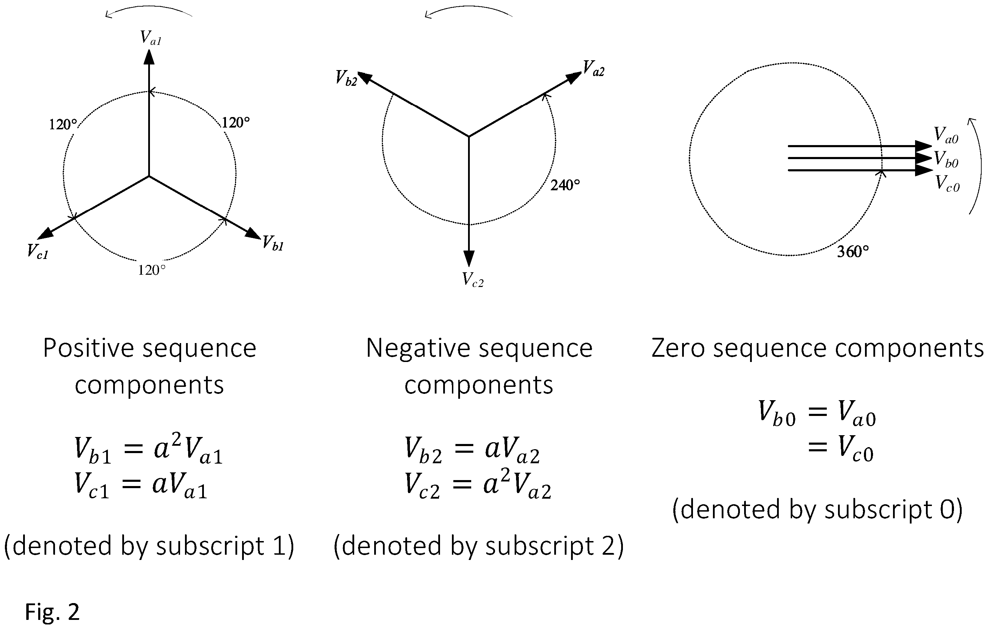

Fig. 2 shows phasor representations of positive sequence voltages $V_{a1}$, $V_{b1}$, $V_{c1}$, negative sequence voltages $V_{a2}$, $V_{b2}$, $V_{c2}$, and zero sequence voltages $V_{a0}$, $V_{b0}$, $V_{c0}$, wherein the subfixes *a, b, c* denote the phase "a", phase "b" and phase "c", respectively, of the three-phase electricity distribution network 1. The general concept of symmetrical components (first developed by Fortescue in 1918) is that an unbalanced system of *n* related phasors of the phases *a*, *b*, *c* can be resolved into n systems of balanced phasors called "symmetrical components" of the original phasors. In the three-phase electricity distribution network 1 of Fig. 1, a set of three unbalanced phasors, e.g. $V_a$, $V_b$, $V_c$ or $I_a$, $I_b$, $I_c$ can be resolved into three balanced systems of phasors, e.g. $V_1$, $V_2$, $V_0$ or $I_1$, $I_2$, $I_0$ as follows:

   i. Positive sequence components, e.g. $V_1$ or $I_1$, consisting of a balanced system of three phasors, e.g. $V_{a1}$, $V_{b1}$, $V_{c1}$ or $I_{a1}$, $I_{b1}$, $I_{c1}$, having the same phase sequence as the original phasors, e.g. $V_a$, $V_b$, $V_c$ or $I_a$, $I_b$, $I_c$;

   ii. Negative sequence components, e.g. $V_2$ or $I_2$, consisting of a balanced system of three phasors, e.g. $V_{a2}$, $V_{b2}$, $V_{c2}$ or $I_{a2}$, $I_{b2}$, $I_{c2}$, having a phase sequence opposite to that of the original phasors, e.g. $V_a$, $V_b$, $V_c$ or $I_a$, $I_b$, $I_c$; and

   iii. Zero sequence components, e.g. $V_0$ or $I_0$, consisting of three phasors, e.g. $V_{a0}$, $V_{b0}$, $V_{c0}$ or $I_{a0}$, $I_{b0}$, $I_{c0}$, being equal in amplitude and phase.

The notation of the zero sequence components is indicated by the subfix "0" (zero), the positive sequence components are denoted herein by the subfix "1" (one), and the negative sequence components are denoted herein by the subfix "2" (two). The phase components for the respective phases a, b, c are denoted herein by subfix "a", "b" and "c", respectively. The neutral (wire) component is denoted by subfix "N".

As shown in Fig. 2, the following relations apply:

| Positive sequence components | Negative sequence components | Zero sequence components |
|---|---|---|
| $V_{b1} = a^2 V_{a1}$ <br> $V_{c1} = a V_{a1}$ | $V_{b2} = a V_{a2}$ <br> $V_{c2} = a^2 V_{a2}$ | $V_{b0} = V_{a0}$ <br> $= V_{c0}$ |
| (denoted by subscript 1) | (denoted by subscript 2) | (denoted by subscript 0) |

The transformation between symmetrical components is performed by applying a complex size operator *a*, which denotes a 120° phase shift, wherein

$$a = e^{i\frac{2\pi}{3}} = \cos(120°) + i\sin(120°)$$

$$\approx -0.5 + i0.866$$

The operators $a^2$ and $a^3$ represent phase shifts of 240° and 360°, respectively. Thus,

$$a^2 = e^{i\frac{4\pi}{3}} = \cos(240°) + i\sin(240°)$$

$$\approx -0.5 - i0.866$$

and

$$a^3 = e^{i\frac{6\pi}{3}} = e^{i2\pi} = \cos(360°) + i\sin(360°)$$
$$= 1.0 + i0.0$$

which implies that

$$a^0 = a^3 = a^6 \,...$$

$$a = a^4 = a^7 \,...$$

$$a^2 = a^5 = a^8 \,...$$

So, the impedance values $Z_a$, $Z_b$, $Z_c$, $Z_N$ for each phase a, b, c and the neutral wire N of the electricity distribution network 1 may be described in form of symmetrical components known as the positive sequence impedance $Z_1$, the negative sequence impedance $Z_2$ and the zero sequence impedance $Z_0$. If the electrical distribution network 1 is balanced, the impedances $Z_a$, $Z_b$, $Z_c$ of the phases a, b, c are equal. By the nature of symmetrical components, the positive-, negative- and zero sequences do not affect each other if the electrical distribution network 1 is balanced, so that they can be estimated independently. At the same time, the positive and negative sequence impedances are equals. By this, it is possible to estimate the positive sequence impedance by the negative sequence impedance. The MILA known from the prior art makes the simplified assumption of a balanced electrical distribution network, wherein the impedances $Z_a$, $Z_b$, $Z_c$ of the phases a, b, c are considered to be equal.

This assumption is given up for the A-MILA described herein. In order to determine the impedance values $Z_a$, $Z_b$, $Z_c$, $Z_N$ for each phase a, b, c and the neutral wire N of the electricity distribution network 1, a transformation matrix T may be defined for transforming the original phase components to symmetrical components, e.g. the phase voltage vector $V_{abc}$ = $\{V_a, V_b, V_c\}$ may be transformed by

$$V_{abc} = TV_{012}$$

to the symmetrical voltage vector $V_{012}$ = $\{V_0, V_1, V_2\}$, wherein

$$T = \begin{bmatrix} 1 & 1 & 1 \\ 1 & a^2 & a \\ 1 & a & a^2 \end{bmatrix}$$

$$\Updownarrow$$

$$T^{-1} = \frac{1}{3}\begin{bmatrix} 1 & 1 & 1 \\ 1 & a & a^2 \\ 1 & a^2 & a \end{bmatrix}$$

and wherein

$$V_{012} = T^{-1}V_{abc}$$

Analogously, the symmetrical currents are calculated by

$$I_{012} = T^{-1}I_{abc}$$

and the transformation of phase impedances into symmetrical impedances are as follows:

$$Z_{012} = T^{-1}Z_{abc}T$$

As assumed for the MILA known in the prior art, in case of line phases with balanced impedances, i.e.

$$Z_a = Z_b = Z_c$$

$$\Downarrow$$

$$Z_{012} = T^{-1} Z_{abc} T = \begin{bmatrix} Z_0 & 0 & 0 \\ 0 & Z_1 & 0 \\ 0 & 0 & Z_2 \end{bmatrix}$$

the impedance matrix $Z_{012}$ is diagonal.

However, as it is a problem of the present disclosure to determine individual impedances for each phase of the electricity distribution network, the simplified assumption of a balanced grid is given up, i.e.

$$Z_a \neq Z_b \neq Z_c$$

If the neutral wire is considered as a reference for determining an impedance of an individual phase impedance, the phase impedance matrix may be denoted as

$$Z_{abc} = \begin{bmatrix} Z_a + Z_N & Z_N & Z_N \\ Z_N & Z_b + Z_N & Z_N \\ Z_N & Z_N & Z_c + Z_N \end{bmatrix}$$

If the transformation is applied to the phase impedance matrix $Z_{abc}$ by calculating

$$Z_{012} = T^{-1} Z_{abc} T$$

$$= \frac{1}{3} \begin{bmatrix} 1 & 1 & 1 \\ 1 & a & a^2 \\ 1 & a^2 & a \end{bmatrix} \begin{bmatrix} Z_a + Z_N & Z_N & Z_N \\ Z_N & Z_b + Z_N & Z_N \\ Z_N & Z_N & Z_c + Z_N \end{bmatrix} \begin{bmatrix} 1 & 1 & 1 \\ 1 & a^2 & a \\ 1 & a & a^2 \end{bmatrix}$$

$$= \frac{1}{3} \begin{bmatrix} 1 & 1 & 1 \\ 1 & a & a^2 \\ 1 & a^2 & a \end{bmatrix} \begin{bmatrix} Z_a + 3Z_N & (Z_a + Z_N) + a^2 Z_N + a Z_N & (Z_a + Z_N) + a Z_N + a^2 Z_N \\ Z_b + 3Z_N & Z_N + a^2(Z_b + Z_N) + a Z_N & Z_N + a(Z_b + Z_N) + a^2 Z_N \\ Z_c + 3Z_N & Z_N + a^2 Z_N + a(Z_c + Z_N) & Z_N + a Z_N + a^2(Z_c + Z_N) \end{bmatrix}$$

the equations $a^0 = a^3 = 1$ and $a = a^4$ and $1 + a + a^2 = 0$ may be used to simplify the impedance matrix $Z_{012}$ to

$$Z_{012} = \begin{bmatrix} Z_0 & z_{10} & z_{20} \\ z_{01} & Z_1 & z_{21} \\ z_{02} & z_{12} & Z_2 \end{bmatrix}$$

wherein the following equations apply:

$$Z_1 = Z_2 = \frac{Z_a + Z_b + Z_c}{3}$$

$$Z_0 = \frac{Z_a + Z_b + Z_c}{3} + 3Z_N = Z_2 + 3Z_N$$

$$z_{01} = z_{12} = z_{20} = Z_a + a Z_b + a^2 Z_c + 3Z_N(1 + a + a^2)$$
$$= Z_a + a Z_b + a^2 Z_c$$

$$z_{02} = z_{10} = z_{21} = Z_a + a^2 Z_b + a Z_c + 3Z_N(1 + a + a^2)$$
$$= Z_a + a^2 Z_b + a Z_c$$

This shows that if the three phase impedances $Z_a$, $Z_b$, $Z_c$ are equal, the off-diagonals of the impedance matrix $Z_{012}$ are zero due to the equation $1 + a + a^2 = 0$. Otherwise, the impedance matrix $Z_{012}$ comprises non-zero off-diagonal values. Further, this shows that the 3x3 impedance matrix $Z_{012}$ can be constructed from the entries of a 2x2 impedance matrix $Z_{02}$ without loss of information

$$Z_{02} = \begin{bmatrix} Z_0 & z_{20} \\ z_{02} & Z_2 \end{bmatrix}$$
$$\Downarrow$$
$$Z_{012} = \begin{bmatrix} Z_0 & z_{02} & z_{20} \\ z_{20} & Z_2 & z_{02} \\ z_{02} & z_{20} & Z_2 \end{bmatrix}$$

Hence, it is possible to construct the phase impedance matrix $Z_{abc}$ based on the entries of $Z_{02}$ as follows:

$$Z_{abc} = TZ_{012}T^{-1} = \begin{bmatrix} Z_a + Z_N & Z_N & Z_N \\ Z_N & Z_b + Z_N & Z_N \\ Z_N & Z_N & Z_c + Z_N \end{bmatrix}$$
$$= \frac{1}{3}\begin{bmatrix} 1 & 1 & 1 \\ 1 & a^2 & a \\ 1 & a & a^2 \end{bmatrix}\begin{bmatrix} Z_0 & z_{02} & z_{20} \\ z_{20} & Z_2 & z_{02} \\ z_{02} & z_{20} & Z_2 \end{bmatrix}\begin{bmatrix} 1 & 1 & 1 \\ 1 & a & a^2 \\ 1 & a^2 & a \end{bmatrix}$$
$$= \frac{1}{3}\begin{bmatrix} 1 & 1 & 1 \\ 1 & a^2 & a \\ 1 & a & a^2 \end{bmatrix}\begin{bmatrix} Z_0 + z_{02} + z_{20} & Z_0 + az_{02} + a^2z_{20} & Z_0 + a^2z_{02} + az_{20} \\ z_{20} + Z_2 + z_{02} & z_{20} + aZ_2 + a^2z_{02} & z_{20} + a^2Z_2 + az_{02} \\ z_{02} + z_{20} + Z_2 & z_{02} + az_{20} + a^2Z_2 & z_{02} + a^2z_{20} + aZ_2 \end{bmatrix}$$

Those entries of the phase impedance matrix $Z_{abc}$ that define the neutral wire impedance $Z_N$, i.e. all the off-diagonal entries of the phase impedance matrix $Z_{abc}$, can be further reduced due to the equations $1 + a + a^2 = 0 \Leftrightarrow a + a^2 = -1$, leading to

$$3Z_N = Z_0 + z_{02} + z_{20} + a(z_{02} + z_{20} + Z_2) + a^2(z_{20} + Z_2 + z_{02})$$
$$= Z_0 + z_{02} + z_{20} + (a + a^2)(z_{02} + z_{20} + Z_2)$$
$$= Z_0 + z_{02} + z_{20} - (z_{02} + z_{20} + Z_2)$$
$$= Z_0 - Z_2$$
$$\Updownarrow$$

$$Z_N = \frac{Z_0 - Z_2}{3}$$

The diagonal entries of the phase impedance matrix $Z_{abc}$ are the sums of the individual phase impedances and the neutral impedance, respectively. The reduced expressions for the individual phase impedances would be

$$Z_a + Z_N = \frac{1}{3}(Z_0 + 2Z_2 + 3z_{02} + 3z_{20})$$
$$Z_a = \frac{1}{3}Z_0 + \frac{2}{3}Z_2 + z_{02} + z_{20} - Z_N$$
$$Z_a = \frac{1}{3}Z_0 + \frac{2}{3}Z_2 + z_{02} + z_{20} - \frac{1}{3}Z_0 + \frac{1}{3}Z_2$$
$$Z_a = Z_2 + z_{02} + z_{20}$$

$$Z_b + Z_N = \frac{1}{3}(Z_0 + 2Z_2 + 3az_{02} + 3a^2z_{20})$$

$$Z_b = \frac{1}{3}Z_0 + \frac{2}{3}Z_2 + az_{02} + a^2z_{20} - Z_N$$

$$Z_b = \frac{1}{3}Z_0 + \frac{2}{3}Z_2 + az_{02} + a^2z_{20} - \frac{1}{3}Z_0 + \frac{1}{3}Z_2$$

$$Z_b = Z_2 + az_{02} + a^2z_{20}$$

$$Z_c + Z_N = \frac{1}{3}(Z_0 + 2Z_2 + 3az_{20} + 3a^2z_{02})$$

$$Z_c = \frac{1}{3}Z_0 + \frac{2}{3}Z_2 + az_{20} + a^2z_{02} - Z_N$$

$$Z_c = \frac{1}{3}Z_0 + \frac{2}{3}Z_2 + az_{20} + a^2z_{02} - \frac{1}{3}Z_0 + \frac{1}{3}Z_2$$

$$Z_c = Z_2 + az_{20} + a^2z_{02}$$

So, each individual phase impedance and the neutral wire impedance can be estimated by the reduced impedance 2x2 matrix $Z_{02}$ that omits the positive sequence component

$$Z_{02} = \begin{bmatrix} Z_0 & z_{20} \\ z_{02} & Z_2 \end{bmatrix}$$

The four impedances to be determined are thus

$$Z_N = \frac{Z_0 - Z_2}{3}$$

$$Z_a = Z_2 + z_{02} + z_{20}$$

$$Z_b = Z_2 + az_{02} + a^2z_{20}$$

$$Z_c = Z_2 + a^2z_{02} + az_{20}$$

which can be described as a four-dimensional vector by

$$Z_{Nabc} = \begin{bmatrix} Z_N \\ Z_a \\ Z_b \\ Z_c \end{bmatrix} = \begin{bmatrix} 1/3 & -1/3 & 0 & 0 \\ 0 & 1 & 1 & 1 \\ 0 & 1 & a & a^2 \\ 0 & 1 & a^2 & a \end{bmatrix} \begin{bmatrix} Z_0 \\ Z_2 \\ z_{02} \\ z_{20} \end{bmatrix}$$

Please note that, in case of a reversed phase rotation direction, the individual phase impedances would be

$$Z_{Nabc} = \begin{bmatrix} Z_N \\ Z_a \\ Z_b \\ Z_c \end{bmatrix} = \begin{bmatrix} 1/3 & -1/3 & 0 & 0 \\ 0 & 1 & 1 & 1 \\ 0 & 1 & a^2 & a \\ 0 & 1 & a & a^2 \end{bmatrix} \begin{bmatrix} Z_0 \\ Z_2 \\ z_{02} \\ z_{20} \end{bmatrix}$$

It should further be noted that the positive sequence component $Z_1$ could be determined instead of the negative sequence component $Z_2$ due to the equation

$$Z_1 = Z_2 = \frac{Z_a + Z_b + Z_c}{3}$$

So, in order to determine the impedance values $Z_a$, $Z_b$, $Z_c$, $Z_N$ for each phase a, b, c and the neutral wire N of the electricity distribution network 1, the zero-sequence impedance $Z_0$, the negative-sequence impedance $Z_2$, and the correlation terms $z_{02}$, $z_{20}$ are determined. This is done based on voltage changes $\Delta V_a$, $\Delta V_b$, $\Delta V_c$ and current changes $\Delta I_a$, $\Delta I_b$, $\Delta I_c$ determined by the electricity meter 7 at each phase a, b, c of the electricity distribution network.

Changes in the zero sequence voltage $\Delta V_0$ and the negative sequence voltage $\Delta V_2$ as well as changes in the zero sequence current $\Delta I_0$ and the negative sequence current $\Delta I_2$ can be determined using the following equations:

$$\Delta V_{02} = \begin{bmatrix} \Delta V_0 \\ \Delta V_2 \end{bmatrix} = \frac{1}{3}\begin{bmatrix} 1 & 1 & 1 \\ 1 & a^2 & a \end{bmatrix}\begin{bmatrix} \Delta V_a \\ \Delta V_b \\ \Delta V_c \end{bmatrix}$$

$$\Delta I_{02} = \begin{bmatrix} \Delta I_0 \\ \Delta I_2 \end{bmatrix} = \frac{1}{3}\begin{bmatrix} 1 & 1 & 1 \\ 1 & a^2 & a \end{bmatrix}\begin{bmatrix} \Delta I_a \\ \Delta I_b \\ \Delta I_c \end{bmatrix}$$

The impedance matrix $Z_{02}$ relates $\Delta V_{02}$ to $\Delta I_{02}$ by:

$$-\Delta V_{02} \propto Z_{02}\Delta I_{02}$$

$$-\begin{bmatrix} \Delta V_0 \\ \Delta V_2 \end{bmatrix} \propto \begin{bmatrix} Z_0 & z_{20} \\ z_{02} & Z_2 \end{bmatrix}\begin{bmatrix} \Delta I_0 \\ \Delta I_2 \end{bmatrix}$$

$$\begin{bmatrix} \left(V_{0_{t_0}} - V_{0_{t_1}}\right) \\ \left(V_{2_{t_0}} - V_{2_{t_1}}\right) \end{bmatrix} \propto \begin{bmatrix} Z_0 & z_{20} \\ z_{02} & Z_2 \end{bmatrix}\begin{bmatrix} \left(I_{0_{t_1}} - I_{0_{t_0}}\right) \\ \left(I_{2_{t_1}} - I_{2_{t_0}}\right) \end{bmatrix}$$

wherein the changes in voltage and current are determined between a first point in time $t_0$ and a second point in time $t_1$.

Thus, the correlation term $z_{20}$ is indicative of a correlation between the zero sequence voltage $V_0$ and the negative sequence current $I_2$, and the correlation term $z_{02}$ is indicative of a correlation between the zero sequence current $I_0$ and the negative sequence voltage $V_2$.

Mathematically, the determination of the impedance matrix $Z_{02}$ can be considered as a model optimisation problem. For example, a least square solution for identifying a model $A$ that maps $x$ into y is

$$y = Ax$$

$$yx^T(xx^T)^{-1} = A$$

For continuously adding new data to the optimal solution for the model, a recursive method may be applied that could be described as

$$S_n = S_{n-1} + x_n x_n^T$$

$$\varepsilon_n = y_n - A_{n-1}x_n$$

$$K_n = S_n^{-1}x_n$$

$$A_n = A_{n-1} + K_n \varepsilon_n^T$$

A problem with this method is that

$$S_n \underset{n\to\infty}{\longrightarrow} +\infty$$

which saturates when n increases to infinity. Different commonly known mathematical methods successfully deal with this problem as well as with the computational effort of inverting $S_n$. Using the "lemma of matrix inversion"

$$(F + GHK)^{-1} = F^{-1} - F^{-1}G(H^{-1} + KF^{-1}G)KF^{-1}$$

It is possible to consider

$$
\begin{array}{ccccccc}
S_n & = & S_{n-1} & + & x_n & \cdot & 1 & \cdot & x_n^T \\
& & \downarrow & & \downarrow & & \downarrow & & \downarrow \\
& & F & & G & & H & & K
\end{array}
$$

$$S_n^{-1} = S_{n-1}^{-1} - S_{n-1}^{-1}x_n(1 + x_n^T S_{n-1}^{-1}x_n)^{-1}x_n^T S_{n-1}^{-1}$$

By defining $B_n \equiv S_n^{-1}$, it follows

$$B_n = B_{n-1} - \frac{B_{n-1}x_n x_n^T B_{n-1}}{1 + x_n^T B_{n-1}x_n}$$

It is further useful to introduce a "forgetting factor $\rho$" which continuously dilutes the matrix $S_n$ for letting the model forget old information and be able to detect changes in the system

$$S_n = \rho S_{n-1} + x_n x_n^T$$

wherein $\rho$ is real and $0 < \rho \le 1$.

Combining this with the "lemma of matrix inversion" it follows

$$B_n = \frac{1}{\rho}\left(B_{n-1} - \frac{B_{n-1}x_n x_n^T B_{n-1}}{\rho + x_n^T B_{n-1}x_n}\right)$$

$$\varepsilon_n = y_n - A_{n-1}^T x_n$$

$$K_n = B_n x_n$$

$$A_n = A_{n-1} + K_n \varepsilon_n^T$$

In order to apply this method, it is beneficial to initialize $B$ at $n = 0$ to a reasonable, non-singular value, e.g. an identity matrix or a scaled version of that. For example, at initialization of the impedance learning algorithm, the following initial values may be applied:

$$nRun = n = 0$$

$$\Delta I_\Sigma = 1$$

$$\Delta I_{a_\Sigma} = 0$$

$$\Delta I_{b\Sigma} = 0$$

$$\Delta I_{c\Sigma} = 0$$

$$B_{n=0} = \begin{bmatrix} 1 & 0 \\ 0 & 1 \end{bmatrix}$$

$$Z_{02_{n=0}} = \begin{bmatrix} 0 & 0 \\ 0 & 0 \end{bmatrix}$$

Alternatively, the impedance matrix $Z_{02_{n=0}}$ may be initialised with the latest estimated values instead of the zero matrix. The initialization values are also reset values whenever the impedance learning algorithm is automatically or manually reset. The number n of optimisation runs and the accumulated change of current $\Delta I_{a_\Sigma}$, $\Delta I_{b_\Sigma}$, $\Delta I_{c_\Sigma}$, which is indicative of an accumulated sum of previously and recently logged changes in the determined current $\Delta I_a$, $\Delta I_b$, $\Delta I_b$, are beneficial to log, because they give an indication about the reliability and confidence of the determined values. In general, the determined values are more reliable with a higher number of optimisation runs and larger accumulated change of currents $\Delta I_{a_\Sigma}$, $\Delta I_{b_\Sigma}$, $\Delta I_{c_\Sigma}$.

For example, the accumulated change of currents $\Delta I_\Sigma$ may be determined by the electricity meter 7 for the respective phase line as

$$\Delta I_{a\Sigma} = \sum_n \left( \frac{\sqrt{P_{at_1 n}^2 + Q_{at_1 n}^2}}{V_{at_1 n}} - \frac{\sqrt{P_{at_0 n}^2 + Q_{at_0 n}^2}}{V_{at_0 n}} \right)$$

$$\Delta I_{b\Sigma} = \sum_n \left( \frac{\sqrt{P_{bt_1 n}^2 + Q_{bt_1 n}^2}}{V_{bt_1 n}} - \frac{\sqrt{P_{bt_0 n}^2 + Q_{bt_0 n}^2}}{V_{bt_0 n}} \right)$$

$$\Delta I_{c\Sigma} = \sum_n \left( \frac{\sqrt{P_{ct_1 n}^2 + Q_{ct_1 n}^2}}{V_{ct_1 n}} - \frac{\sqrt{P_{ct_0 n}^2 + Q_{ct_0 n}^2}}{V_{ct_0 n}} \right)$$

wherein n denotes the number of conducted optimisation runs of the determined phase impedances, P is the active power and Q is the reactive power on the respective phase a, b, c at the respective points in time $t_1$ and $t_0$.

When it comes to actually determining the phase currents $I_a$, $I_b$, $I_c$, it may be difficult to calculate the phasors directly. It may be easier to derive the current phasors from the complex power S, which is determined anyway by the electricity meter 7 in its primary task to determine electricity consumption. The complex power S also serves to attenuate unpredictable harmonic content in the root-mean-squared currents. Thus, the current phasor may be derived from the voltage V and complex power S to be

$$\vec{I}_x = \left( \frac{\vec{S}_x}{\vec{V}_x} \right)^*$$

$$\vec{I}_x = \frac{P_x - jQ_x}{\vec{V}_x^*}$$

It is an unusual task for an electricity meter 7 to determine voltage phasors $\vec{V}_x$. In one embodiment, the impedance learning algorithm may determine voltage phasors $\vec{V}_x$. In one embodiment, the impedance learning algorithm may determine the voltage phasors $\vec{V}_x$ simply by root-mean-square amplitudes of the voltages and the phase displacement between respective phases and a reference phase, e.g. phase a. The voltage phasors may then be determined as

$$\vec{V_a} = V_{RMS_a}$$

$$\vec{V_b} = V_{RMS_b} \cdot (\cos(\angle V_{ab}) + j \sin(\angle V_{ab}))$$

$$\vec{V_c} = V_{RMS_c} \cdot (\cos(\angle V_{ac}) + j \sin(\angle V_{ac}))$$

wherein $\angle V_{ab}$ is the phase angle between phase a and b, and wherein $\angle V_{ac}$ is the phase angle between phase a and c.

Before the impedance learning algorithm is actually updating or logging the determined impedance values, it is beneficial to check if the system is in a normal state. This can be checked by applying preconditions which are preferably configurable algorithm parameters. For example, a "normal voltage range" may be defined, e.g.

$$184V \leq V_{a,b,c} \leq 276V$$

Furthermore, a "normal phase angle range" may be defined, e.g.

$$80.00° \leq \angle V_{ab,ac} \leq 160.00°$$

and

$$200.00° \leq \angle V_{ac,ab} \leq 280.00°$$

Finally, it could be tested if the frequency is stable in terms of a rate of change of frequency (ROCOF), which is the time derivative of the fundamental frequency of the electricity distribution network 1.

The conditions above are preferably verified before updating or logging determined values, so that the risk of potentially corrupt data contaminating previously determined correct data is reduced.

After the phase voltages $V_{a,b,c}$ and phase currents $I_{a,b,c}$ are determined, the determination of the associated symmetrical components for voltage $V_{0,1,2}$ and current $I_{0,1,2}$ follows. To calculate the zero- and negative sequence components $V_{0,2}$, $I_{0,2}$ from the phasors $V_{a,b,c}$, $I_{a,b,c}$ it is beneficial to determine the phase rotation direction which depends on how the connection terminals 9 of the electricity meter 7 are connected to the phases a, b and, respectively, i.e.:

$$\angle V_{ab} > \angle V_{ac} \Rightarrow T_{02}^{\text{inv}} = \frac{1}{3} \begin{bmatrix} 1 & 1 & 1 \\ 1 & a^2 & a \end{bmatrix}$$

$$\angle V_{ab} < \angle V_{ac} \Rightarrow T_{02}^{\text{inv}} = \frac{1}{3} \begin{bmatrix} 1 & 1 & 1 \\ 1 & a & a^2 \end{bmatrix}$$

The former is the case as defined above and the latter is applied if the phase rotation direction is reversed. The transformation matrix T is used to calculate the symmetrical components $V_{0,2}$, $I_{0,2}$ further used in the impedance learning algorithm

$$V_{02} = \begin{bmatrix} V_0 \\ V_2 \end{bmatrix} = T_{02}^{\text{inv}} \begin{bmatrix} \vec{V_a} \\ \vec{V_b} \\ \vec{V_c} \end{bmatrix}$$

$$I_{02} = \begin{bmatrix} I_0 \\ I_2 \end{bmatrix} = T_{02}^{\text{inv}} \begin{bmatrix} \vec{I_a} \\ \vec{I_b} \\ \vec{I_c} \end{bmatrix}$$

The impedance learning algorithm determines changes in symmetric components $V_{0,2}$, $I_{0,2}$. Those are calculated by

$$\Delta V_{02_{t_1}} = V_{02_{t_1}} - V_{02_{t_0}}$$

$$\Delta I_{02_{t_1}} = I_{02_{t_1}} - I_{02_{t_0}}$$

wherein the changes in voltage and current are determined between a first point in time $t_0$ and a second point in time $t_1$.

Before the impedance learning algorithm uses the determined values for optimisation, it is advantageous to ensure the presence of a significant change in either zero- or negative sequence current that must be drawn by a change in load rather than a change in supply voltage. For that, the following conditions may be applied:

$$\frac{k}{4}\frac{|\Delta V_0|}{|\Delta I_0|} < \left(\frac{V_{RMS}}{I_{RMS}}\right)_{MIN} \text{ or } k\frac{|\Delta V_2|}{|\Delta I_2|} < \left(\frac{V_{RMS}}{I_{RMS}}\right)_{MIN}$$

It is acceptable that the condition may theoretically only be fulfilled for either the zero sequence components or the negative sequence components. However, in practice, they will normally be similarly sized. The right-hand term $\left(\frac{V_{RMS}}{I_{RMS}}\right)_{MIN}$ may be referred to as a load factor, which may be determined by

$$\left(\frac{V_{RMS}}{I_{RMS}}\right)_{MIN} = \min\left\{\frac{V_a^2}{\sqrt{P_a^2 + Q_a^2}}, \quad \frac{V_b^2}{\sqrt{P_b^2 + Q_b^2}}, \quad \frac{V_c^2}{\sqrt{P_c^2 + Q_c^2}}\right\}$$

For practical reasons, it could be beneficial to apply a different condition for avoiding division-by-zero issues. It's a free choice to test on the admittance Y rather than impedance Z to avoid infinite values, i.e.

$$\left(\frac{I_{RMS}}{V_{RMS}}\right)_{MAX} = \max\left\{\frac{\sqrt{P_a^2 + Q_a^2}}{V_a^2}, \quad \frac{\sqrt{P_b^2 + Q_b^2}}{V_b^2}, \quad \frac{\sqrt{P_c^2 + Q_c^2}}{V_c^2}\right\}$$

$$4 \cdot \frac{|\Delta I_0|}{|\Delta V_0|} > k\left(\frac{I_{RMS}}{V_{RMS}}\right)_{MAX} \text{ or } \frac{|\Delta I_2|}{|\Delta V_2|} > k\left(\frac{I_{RMS}}{V_{RMS}}\right)_{MAX}$$

The impedance learning algorithm may use the values for optimisation if either one of the above conditions is fulfilled. However, a further condition may be applied to avoid disimproving by "optimising" based on values that were determined from arbitrary small current changes in near no-load situations. Such a further test could be

$$|\Delta I_0| > \Delta I_{UPDATE\_LIMIT} \text{ or } |\Delta I_1| > \Delta I_{UPDATE\_LIMIT}$$

Once the above conditions have been verified, the impedance learning algorithm may proceed to optimise the impedance values.

The impedance learning algorithm may increase a counter *n* or *nRun* for each run when it optimises the determined values. The counter value *n* or *nRun* is logged together with the determined values, because it can be used as an indicator for the reliability or the confidence of the determined values. The counter value *n* or *nRun* may be reset automatically when a pre-defined limit is reached, an auto-reset is triggered and/or on demand.

In order to be sensitive to changes of the impedance, it is advantageous if the impedance learning algorithm determines a "forgetting factor $\rho$" for reducing the weight of past observations and for giving more weight to recent observations. The forgetting factor $\rho$ may be defined it in different ways, e.g. as a static decimal value $0 < \rho \leq 1$ and/or as an amount of current, which could be adaptively adjusted to the specific load pattern at the consumer site behind the electricity meter 7. It is possible to define a configuration parameter

$$\text{F\_FACTOR} \in \{x :\in \mathbb{N} \mid x < 2^{16}\}$$

wherein the configuration parameter F_FACTOR is limited only for practical reasons. Depending on whether the F_FACTOR is below or above 100, the forgetting factor may be defined as

$$\text{F\_FACTOR} < 100 \Rightarrow \rho = 1 - \frac{\text{F\_FACTOR}}{1000}$$

$$\text{F\_FACTOR} \geq 100 \Rightarrow \rho = \frac{\alpha}{\alpha + |\Delta I_0| + |\Delta I_2|}$$

wherein

$$\alpha = \min\{\text{F\_FACTOR}, \Delta I_\Sigma\}$$

and

$$\Delta I_\Sigma = \sum_n |\Delta I_0[n]| + |\Delta I_2[n]|$$

wherein $\Delta I_\Sigma$ is the accumulated sum of current changes per run, which could be limited to a maximum value like F_FACTOR.

Once the forgetting factor is calculated, the impedance learning algorithm proceeds by calculating the numerator *num* and the denominator *den* of the optimised value of $B_n$

$$num = B_{n-1}\Delta I_{02_n}\Delta I_{02_n}^T B_{n-1}$$

$$den = \rho + \Delta I_{02_n}^T B_{n-1}\Delta I_{02_n}$$

and further optimising

$$B_n = \frac{1}{\rho}\left(B_{n-1} - \frac{\text{num}}{\text{den}}\right)$$

wherein the denominator is a scalar. Next, a kind of estimation error $\varepsilon$ and error gain K is calculated

$$\varepsilon = \Delta V_{02_n} + Z_{02_{n-1}}^T \Delta I_{02_n}$$

$$K = B_n \Delta I_{02_n}$$

and finally, the impedance matrix is optimised to be:

$$Z_{02_n} = Z_{02_{n-1}}^T - K\varepsilon^T$$

The impedance values may be extracted from the latest optimised version of $Z_{02}$. The zero-sequence resistance $R_0$ and reactance $X_0$ are the real and imaginary part of $Z_0$, respectively, i.e.

$$R_0 = \Re\{Z_{02}[0,0]\}$$

$$X_0 = \Im\{Z_{02}[0,0]\}$$

The negative-sequence resistance $R_2$ and reactance $X_2$ are the real and imaginary part of $Z_2$, respectively, i.e.

$$R_2 = \Re\{Z_{02}[1,1]\}$$

$$X_2 = \Im\{Z_{02}[1,1]\}$$

The neutral wire resistance $R_N$ and reactance $X_N$ are the real and imaginary part as follows

$$R_N = \Re\left\{\frac{1}{3}(Z_{02}[0,0] - Z_{02}[1,1])\right\}$$

$$X_N = \Im\left\{\frac{1}{3}(Z_{02}[0,0] - Z_{02}[1,1])\right\}$$

The resistance $R_a$ and reactance $X_a$ of line "a" are the real and imaginary part as follows

$$R_a = \Re\{Z_{02}[1,1] + Z_{02}[0,1] + Z_{02}[1,0]\}$$

$$X_a = \Im\{Z_{02}[1,1] + Z_{02}[0,1] + Z_{02}[1,0]\}$$

The impedances of line "b" and "c" are determined depending of the phase rotation direction. During positive rotation a -> b -> c, we have

$$a = e^{i\frac{2\pi}{3}} = \cos(120°) + i\sin(120°) \approx -0.5 + i0.866$$

and

$$a^2 = e^{i\frac{4\pi}{3}} = \cos(240°) + i\sin(240°) \approx -0.5 - i0.866$$

So that the resistance $R_b$ and reactance $X_b$ of line "b" in case of positive rotation are the real respectively and imaginary part as follows

$$R_b = \Re\{Z_{02}[1,1] + aZ_{02}[0,1] + a^2Z_{02}[1,0]\}$$

$$X_b = \Im\{Z_{02}[1,1] + aZ_{02}[0,1] + a^2Z_{02}[1,0]\}$$

The resistance $R_c$ and reactance $X_c$ of line "c" in case of positive rotation are the real and imaginary part as follows

$$R_c = \Re\{Z_{02}[1,1] + a^2Z_{02}[0,1] + aZ_{02}[1,0]\}$$

$$X_c = \Im\{Z_{02}[1,1] + a^2Z_{02}[0,1] + aZ_{02}[1,0]\}$$

During negative rotation a -> c -> b, the impedances of line "b" and "c" are reversed, which gives

$$R_b = \Re\{Z_{02}[1,1] + a^2Z_{02}[0,1] + aZ_{02}[1,0]\}$$

$$X_b = \Im\{Z_{02}[1,1] + a^2 Z_{02}[0,1] + a Z_{02}[1,0]\}$$

and

$$R_c = \Re\{Z_{02}[1,1] + a Z_{02}[0,1] + a^2 Z_{02}[1,0]\}$$

$$X_c = \Im\{Z_{02}[1,1] + a Z_{02}[0,1] + a^2 Z_{02}[1,0]\}$$

Several figures are of interest to determine the confidence in the estimated impedances. A very useful figure in this respect may be the accumulated sum of current changes per phase that the algorithm has used, i.e. $\Delta I_{a_\Sigma}$, $\Delta I_{b_\Sigma}$ and $\Delta I_{c_\Sigma}$. In general, the higher the figure is the more reliable the estimated impedance is. The number n of optimisation runs and/or an estimation error or an estimation error function may be used in addition or alternatively to evaluate the confidence.

It is further beneficial to adapt the parameter configuration parameter F_FACTOR depending on another configuration parameter

$$\text{F\_ADAPTIVE} \in \{x : \in \mathbb{N} \mid x < 2^8\}.$$

If F_ADAPTIVE is set to zero, F_FACTOR will not be adapted. Otherwise, F_FACTOR may be adapted as follows:

$$\text{F\_ADAPTIVE} > 0 \Rightarrow \text{F\_FACTOR}$$
$$= \max\{(\text{F\_ADAPTIVE} \cdot min\{\Delta I_{a_\Sigma}, \Delta I_{b_\Sigma}, \Delta I_{c_\Sigma}\}), 100\}$$

This example would mean that it is not possible to adapt F_FACTOR to a value less than 100A. In case F_FACTOR is adapted, the optimisation run counter $n$, the accumulated values $\Delta I_{a_\Sigma}$, $\Delta I_{b_\Sigma}$, $\Delta I_{c_\Sigma}$ and also $\Delta I_\Sigma$ are preferably automatically reset to zero (auto-reset).

The impedance learning algorithm may preferably log the determined values at the end of pre-defined logging intervals, e.g. after each full hour or once per day at a pre-defined clock time. The determined and logged data may be stored in a memory of the electricity meter 7 and/or transmitted to a head-end-system HES. The logged data may be buffered over a plurality of logging intervals before the logged data is transmitted. Alternatively, the logged data is transmitted after each logging interval or when consumption data is transmitted according to a transmission schedule. The impedance learning algorithm may perform an auto-reset after each logging interval to reset the values to initial values.

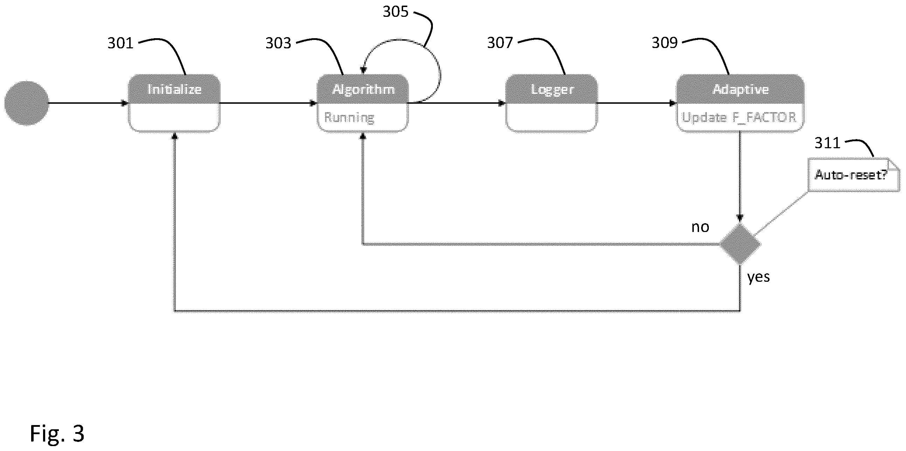

Fig. 3 shows schematically how an example of the impedance learning algorithm works. After initializing 301, the optimisation is run 303 during a pre-determined logging interval. The determined impedance values are determined by updating the values in a plurality of re-iterated optimisation runs 305 fulfilling pre-defined criteria. After the end of the logging interval, the determined values are logged 307 and the adaptive configuration parameter F_FACTOR is adapted 309. Depending on the whether an auto-reset 311 is switched on or not, the method loop returns to the initializing step 301 if it is switched on, or to the running step 303 if it is switched off. Thus, if the auto-reset 311 is switched off, the next logging interval starts with the values determined in the previous logging interval.

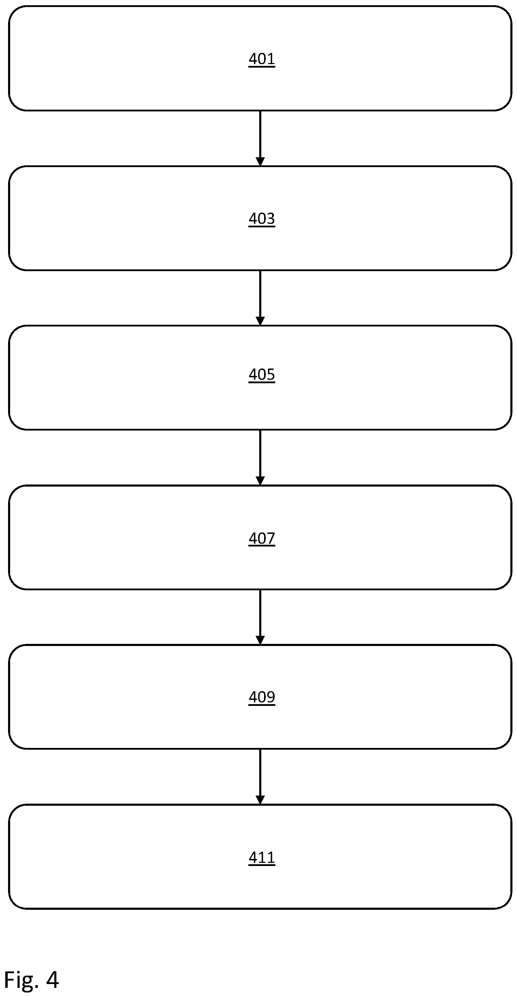

Fig. 4 shows schematically the method steps that are preferably performed by the electricity meter 7. First of all, the voltage $V_a$, $V_b$, $V_c$ and a current $I_a$, $I_b$, $I_c$ is determined 401 at each phase a, b, c of the electricity distribution network 1 by means of electricity meter 1. As the primary task of the electricity meter 1 the electricity consumption is calculated 403. It follows a step of determining 405, by the electricity meter 1, based on a plurality of changes in the measured voltage $\Delta V_a$, $\Delta V_b$, $\Delta V_c$ and current $\Delta I_a$, $\Delta I_b$, $\Delta I_c$ at each phase of the electricity distribution network, a zero sequence impedance $Z_0$ and a negative sequence impedance $Z_2$ of the electricity distribution network. Furthermore, it follows a step of determining 407 an impedance value $Z_a$, $Z_b$, $Z_c$ for each phase of the electricity distribution network by determining correlation terms $z_{20}$, $z_{02}$, wherein the correlation term $z_{20}$ is indicative of a correlation between a zero sequence voltage $V_0$ and a negative sequence current $I_2$, and wherein the correlation term $z_{02}$ is indicative of a correlation between a zero sequence current $I_0$ and a negative sequence voltage $V_2$.

As a preferred optional step, the determined impedance value $Z_a$, $Z_b$, $Z_c$ for each phase a, b, c of the electricity distribution network 1 and an impedance value $Z_N$ for a neutral wire N of the electricity distribution network 1 are iteratively optimised 409. The optimisation step 409 may be performed during a pre-defined logging interval after which the optimised values are logged 411. The logged values may be stored, buffered and/or transmitted to a head-end-system HES.

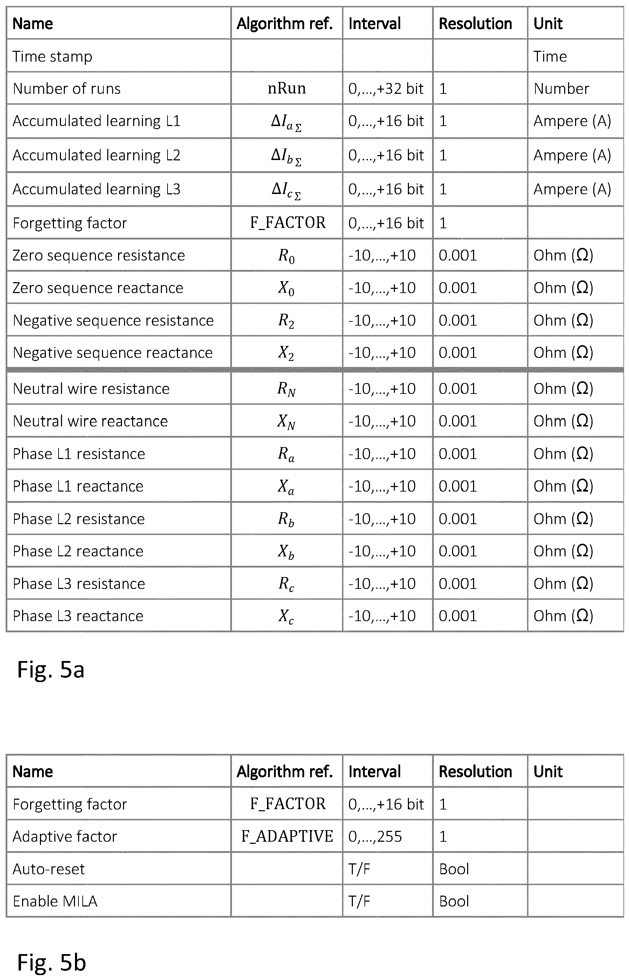

Fig. 5a shows a table of determined and logged data that may be stored, buffered and/or transmitted to the head-end-system HES. Please note that in Fig. 5a phase "a" is denoted as "L1", phase "b" is denoted as "L2", and phase "c" is denoted as "L3".

Fig. 5b shows a table of configuration parameters that can be set to configure the impedance learning algorithm. The electricity meter 7 may receive such a configuration table from the head-end-system HES in order to be configured. In addition, the configuration table may be stored together with the logged data and transmitted to the head-end-system HES in order to have a record of the configuration parameters that were used for determining the associated logged data.

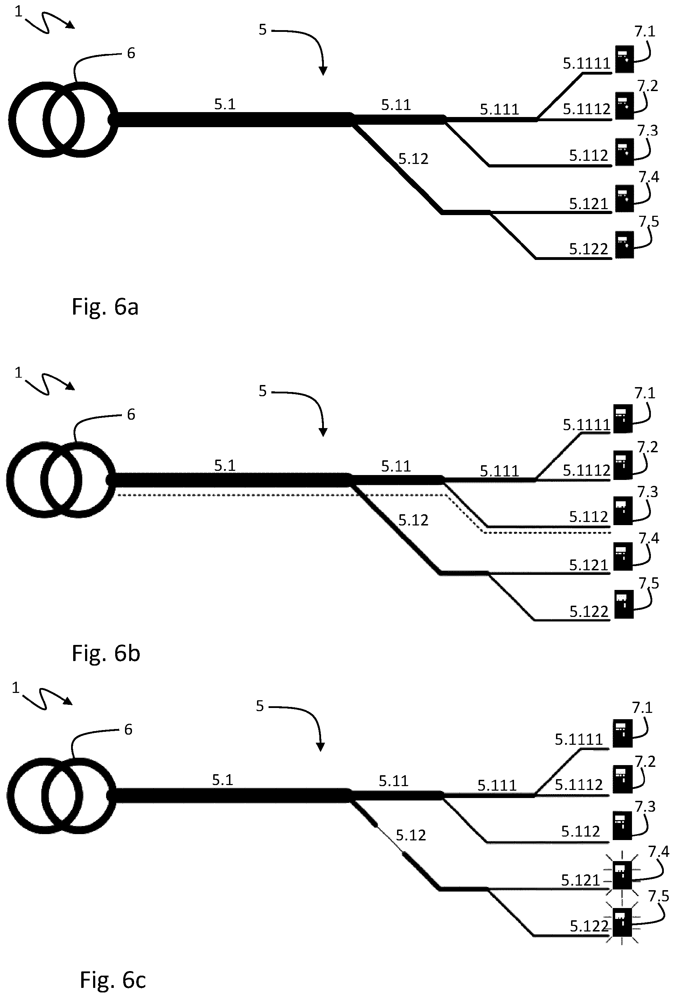

Figs. 6a-c show schematically a lowest voltage distribution network level 5 of a three-phase electricity distribution system 1 providing electric energy for five different customer sites (not shown) that are each equipped with an electricity meter 7.1, 7.2, 7.3, 7.4, 7.5. The distribution network level 5 of the three-phase electricity distribution system 1 comprises different network segments 5.1, 5.11, 5.12, 5.111, 5.112, 5.1111, 5.1112, 5.121, and 5.122, via which the electricity meters 7.1, 7.2, 7.3, 7.4, 7.5 are connected to the transformer station 6.

For example, as indicated in Fig. 6b by the dotted line, the electricity meter 7.3 is connected to the transformer station 6 via network segments 5.1, 5.11, 5.112. The impedance determined by the electricity meter 7.3 is thus the accumulated impedance of the three network segments 5.1, 5.11, 5.112 located between the electricity meter 7.3 and the transformer station 6. As each electricity meter 7.1, 7.2, 7.3, 7.4, 7.5 is connected via its individual unique path of network segments, each electricity meter 7.1, 7.2, 7.3, 7.4, 7.5 sees, strictly speaking, a different impedance. Some of the network segments, e.g. 5.1, 5.11, 5.12, and 5.111 serve more than one consumer site, or, in other words, some consumer site share certain network segments, e.g. 5.1, 5.11, 5.12, and 5.111 to be connected to the transformer station 6. As the advanced MILA (A-MILA) described herein determines the accumulated impedance of all network segments between the transformer station 6 and the electricity meter 7.1, 7.2, 7.3, 7.4, 7.5.

For example, as shown in Fig. 6c, the network segment 5.12 has a weakness which shows as an increased impedance at the two electricity meters 7.4, 7.5, because these two electricity meters 7.4, 7.5 share the network segment 5.12. If the weakness were in network segment 5.1, all electricity meters 7.1, 7.2, 7.3, 7.4, 7.5 would determine an increased impedance. One advantage of determining the impedance individually for each phase line and the neutral wire is that the weakness in a certain phase of the shared network segment 5.12 will be detected by the connected electricity meters 7.4, 7.5 as an increased impedance on the same phase. That reduces significantly the risk of statistical coincidence and increases the confidence in the determined impedance values. Furthermore, maintenance and repair action may be more effectively and efficiently focussed on the affected phase line at the affected network segment 5.12.

Reference should be made to the claims for determining the true scope of the present disclosure. It will also be appreciated by the reader that integers or features of the disclosure that are described as optional, preferable, advantageous, convenient or the like are optional and do not limit the scope of the independent claims.

The above embodiments are to be understood as illustrative examples of the disclosure. While at least one exemplary embodiment has been shown and described, it should be understood that other modifications, substitutions and alternatives are apparent to one of ordinary skill in the art and may be changed without departing from the scope of the subject matter described herein, and this application is intended to cover any adaptations or variations of the specific embodiments discussed herein.

In addition, "comprising" does not exclude other elements or steps, and "a" or "one" does not exclude a plural number. Method steps may be applied in any order or in parallel or may constitute a part or a more detailed version of another method step. It should be understood that there should be embodied within the scope of the patent warranted hereon all such modifications as reasonably and properly come within the scope of the contribution to the art. Such modifications, substitutions and alternatives can be made without departing from the scope of the disclosure, which should be determined from the appended claims.

List of reference numerals:

| | |
|---|---|
| 1 | three-phase electricity distribution network |
| 3 | transmission network level |
| 5 | distribution network level |
| 7 | electricity meter |
| 9 | connection terminals |
| 11 | circuit |
| 13 | microcontroller |
| 15 | communication interface |
| 17 | communication network |
| 19 | automatic metering infrastructure (AMI) |
| HES | head-end-system |

**Claims**

1. An electricity meter (7) for determining electricity consumption in a three-phase electricity distribution network (1), wherein the electricity meter (7) comprises:

   - a circuit (11) for determining a voltage $V_a$, $V_b$, $V_c$ and a current $I_a$, $I_b$, $I_c$ at each phase (a, b, c) of the electricity distribution network (1),
   - at least one microcontroller (13) for calculating electricity consumption from the electricity distribution network (1), and
   - an impedance learning algorithm for being executed by the at least one microcontroller (13), wherein the impedance learning algorithm is configured to determine, based on a plurality of changes in the determined voltage $\Delta V_a$, $\Delta V_b$, $\Delta V_c$ and current $\Delta I_a$, $\Delta I_b$, $\Delta I_c$ at each phase of the electricity distribution network (1), a zero sequence impedance $Z_0$ and a negative sequence impedance $Z_2$ of the electricity distribution network (1),

   **characterised in that**
   the impedance learning algorithm is configured to determine an impedance value $Z_a$, $Z_b$, $Z_c$ for each phase (a, b, c) of the electricity distribution network (1) by determining correlation terms $z_{20}$, $z_{02}$, wherein the correlation term $z_{20}$ is indicative of a correlation between a zero sequence voltage $V_0$ and a negative sequence current $I_2$, and wherein the correlation term $z_{02}$ is indicative of a correlation between a zero sequence current $I_0$ and a negative sequence voltage $V_2$.

2. The electricity meter (7) according to claim 1, wherein the impedance learning algorithm is configured to include, for the determination of the zero sequence impedance $Z_0$ and the negative sequence impedance $Z_2$ as well as the correlation terms $z_{20}$, $z_{02}$, only those changes in the determined voltage $\Delta V_a$, $\Delta V_b$, $\Delta V_c$ and current $\Delta I_a$, $\Delta I_b$, $\Delta I_c$ for which the relative change in current $\Delta I_a/I_a$, $\Delta I_b/I_b$, $\Delta I_c/I_c$ is a factor $k > 1$, preferably $k \gg 1$, larger than the relative change in voltage $\Delta V_a/V_a$, $\Delta V_b/V_b$, $\Delta V_c/V_c$.

3. The electricity meter (7) according to claim 1 or 2, wherein the impedance learning algorithm is configured to determine the correlation terms $z_{20}$, $z_{02}$ as follows:

$$z_{20} = -\frac{\Delta V_0}{\Delta I_2} - Z_0 \frac{\Delta I_0}{\Delta I_2} = -\frac{\Delta V_a + \Delta V_b + \Delta V_c}{\Delta I_a + a^2 \Delta I_b + a \Delta I_c} - Z_0 \frac{\Delta I_a + \Delta I_b + \Delta I_c}{\Delta I_a + a^2 \Delta I_b + a \Delta I_c},$$

$$z_{02} = -\frac{\Delta V_2}{\Delta I_0} - Z_2 \frac{\Delta I_2}{\Delta I_0} = -\frac{\Delta V_a + a^2 \Delta V_b + a \Delta V_c}{\Delta I_a + \Delta I_b + \Delta I_c} - Z_2 \frac{\Delta I_a + a^2 \Delta I_b + a \Delta I_c}{\Delta I_a + \Delta I_b + \Delta I_c},$$

   wherein $a = e^{i\frac{2\pi}{3}}$ is a complex operator to account for a nominal 120° phase shift between the phases (a, b, c).

4. The electricity meter (7) according to claim 3, wherein the impedance learning algorithm is configured to determine individually the impedance value $Z_a$, $Z_b$, $Z_c$ for each phase (a, b, c) of the electricity distribution network (1) and an impedance value $Z_N$ for a neutral wire (N) of the electricity distribution network (1) as follows:

$$Z_a = Z_2 + z_{20} + z_{02},$$

$$Z_b = Z_2 + a^2 z_{20} + a z_{02},$$

$$Z_c = Z_2 + a z_{20} + a^2 z_{02},$$

   and

$$Z_N = \frac{1}{3}(Z_0 - Z_2).$$

5. The electricity meter (7) according to any of the preceding claims, wherein the impedance learning algorithm is configured to determine the changes in the determined voltage $\Delta V_a$, $\Delta V_b$, $\Delta V_c$ and current $\Delta I_a$, $\Delta I_b$, $\Delta I_c$ based on the voltage $V_a$, $V_b$, $V_c$ and current $I_a$, $I_b$, $I_c$ determined at different points in time $t_0$ and $t_1$, wherein the difference between $t_0$ and $t_1$ is below five minutes.

6. The electricity meter (7) according to any of the preceding claims, wherein the impedance learning algorithm is configured to iteratively optimise the impedance value $Z_a$, $Z_b$, $Z_c$ for each phase (a, b, c) of the electricity distribution network (1) and an impedance value $Z_N$ for a neutral wire (N) of the electricity distribution network (1).

7. The electricity meter (7) according to any of the preceding claims, wherein the impedance learning algorithm is configured to log, after having determined the impedance value $Z_a$, $Z_b$, $Z_c$ for each phase (a, b, c) and an impedance value $Z_N$ for a neutral wire (N) of the electricity distribution network (1), an accumulated change of current $\Delta I_{a\Sigma}$, $\Delta I_{b\Sigma}$, $\Delta I_{c\Sigma}$ indicative of an accumulated sum of previously determined changes in the current $\Delta I_a$, $\Delta I_b$, $\Delta I_c$.

8. A method for determining impedance values in a three-phase electricity distribution network (1), wherein the method comprises:

   - determining (401) a voltage $V_a$, $V_b$, $V_c$ and a current $I_a$, $I_b$, $I_c$ at each phase of the electricity distribution network (1) by means of at least one electricity meter (7) for determining electricity consumption in a three-phase electricity distribution network (1),
   - calculating (403) electricity consumption from the electricity distribution network (1) by means of said at least one electricity meter (7), and
   - determining (405) by said at least one electricity meter (7), based on a plurality of changes in the determined voltage $\Delta V_a$, $\Delta V_b$, $\Delta V_c$ and current $\Delta I_a$, $\Delta I_b$, $\Delta I_c$ at each phase of the electricity distribution network (1), a zero sequence impedance $Z_0$ and a negative sequence impedance $Z_2$ of the electricity distribution network,

   **characterised in that**
   the method further comprises determining (407) an impedance value $Z_a$, $Z_b$, $Z_c$ for each phase (a, b, c) of the electricity distribution network (1) by determining correlation terms $z_{20}$, $z_{02}$, wherein the correlation term $z_{20}$ is indicative of a correlation between a zero sequence voltage $V_0$ and a negative sequence current $I_2$, and wherein the correlation term $z_{02}$ is indicative of a correlation between a zero sequence current $I_0$ and a negative sequence voltage $V_2$.

9. The method according to claim 8, wherein only those changes in the determined voltage $\Delta V_a$, $\Delta V_b$, $\Delta V_c$ and current $\Delta I_a$, $\Delta I_b$, $\Delta I_c$ for which the relative change in current $\Delta I_a/I_a$, $\Delta I_b/I_b$, $\Delta I_c/I_c$ is a factor $k > 1$ larger than the relative change in voltage $\Delta V_a/V_a$, $\Delta V_b/V_b$, $\Delta V_c/V_c$ are included for the determination of the zero sequence impedance $Z_0$ and the negative sequence impedance $Z_2$ as well as the correlation terms $z_{20}$, $z_{02}$.

10. The method according to claim 8 or 9, the correlation terms $z_{20}$, $z_{02}$ are determined as follows:

$$z_{20} = -\frac{\Delta V_0}{\Delta I_2} - Z_0 \frac{\Delta I_0}{\Delta I_2} = -\frac{\Delta V_a + \Delta V_b + \Delta V_c}{\Delta I_a + a^2 \Delta I_b + a \Delta I_c} - Z_0 \frac{\Delta I_a + \Delta I_b + \Delta I_c}{\Delta I_a + a^2 \Delta I_b + a \Delta I_c},$$

$$z_{02} = -\frac{\Delta V_2}{\Delta I_0} - Z_2 \frac{\Delta I_2}{\Delta I_0} = -\frac{\Delta V_a + a^2 \Delta V_b + a \Delta V_c}{\Delta I_a + \Delta I_b + \Delta I_c} - Z_2 \frac{\Delta I_a + a^2 \Delta I_b + a \Delta I_c}{\Delta I_a + \Delta I_b + \Delta I_c},$$

wherein $a = e^{i\frac{2\pi}{3}}$ is a complex operator to account for a nominal 120° phase shift between the phases.

11. The method according to claim 10, wherein the impedance value $Z_a$, $Z_b$, $Z_c$ for each phase (a, b, c) of the electricity distribution network (1) and an impedance value $Z_N$ for a neutral wire (N) of the electricity distribution network (1) are individually determined as follows:

$$Z_a = Z_2 + z_{20} + z_{02},$$

$$Z_b = Z_2 + a^2 z_{20} + a z_{02},$$

$$Z_c = Z_2 + az_{20} + a^2 z_{02},$$

and

$$Z_N = \frac{1}{3}(Z_0 - Z_2).$$

12. The method according to any of the claims 8 to 11, wherein the changes in the determined voltage $\Delta V_a$, $\Delta V_b$, $\Delta V_c$ and current $\Delta I_a$, $\Delta I_b$, $\Delta I_c$ are determined based on the voltage $V_a$, $V_b$, $V_c$ and current $I_a$, $I_b$, $I_c$ determined at different points in time $t_0$ and $t_1$, wherein the difference between $t_0$ and $t_1$ is below five minutes.

13. The method according to any of the claims 8 to 12, wherein only those changes in the determined voltage $\Delta V_a$, $\Delta V_b$, $\Delta V_c$ and current $\Delta I_a$, $\Delta I_b$, $\Delta I_c$ for which the determined voltage $V_a$, $V_b$, $V_c$ or the determined current $I_a$, $I_b$, $I_c$ is above a minimum threshold $V_{min}$, $I_{min}$ are included for the determination of the zero sequence impedance $Z_0$ and the negative sequence impedance $Z_2$ as well as the correlation terms $z_{20}$, $z_{02}$.

14. The method according to any of the claims 8 to 13, wherein the determined impedance value $Z_a$, $Z_b$, $Z_c$ for each phase (a, b, c) of the electricity distribution network and an impedance value $Z_N$ for a neutral wire (N) of the electricity distribution network (1) are iteratively optimised.

15. A system for determining electricity consumption in a three-phase electricity distribution network (1), wherein the system comprises:

- a plurality of electricity meters (7) according to any of the claims 1 to 7 being installed at electricity consumer sites in the three-phase electricity distribution network (1), and
- a head-end system (HES) in signal-connection with the plurality of electricity meters (7) for automatically collecting electricity consumption information from the consumer sites, wherein the head-end system (HES) is configured to collect from the electricity meters (7) an impedance value $Z_a$, $Z_b$, $Z_c$ for each phase (a, b, c) of the electricity distribution network (1).

16. The system according to claim 15, wherein the head-end system (HES) is further configured to collect from the electricity meters (7) an impedance value $Z_N$ for a neutral wire (N) of the electricity distribution network (1).

**Patentansprüche**

1. Stromzähler (7) zum Bestimmen des Stromverbrauchs in einem Drehstromverteilungsnetz (1), wobei der Stromzähler (7)

- eine Schaltung (11) zum Bestimmen einer Spannung $V_a$, $V_b$, $V_c$ und eines Stroms $I_a$, $I_b$, $I_c$ bei jeder Phase (a, b, c) des Stromverteilungsnetzes (1),
- wenigstens eine Mikrosteuerung (13) zum Berechnen des Stromverbrauchs von dem Stromverteilungsnetz (1) und
- einen Impedanzlernalgorithmus zur Ausführung durch die wenigstens eine Mikrosteuerung (13), wobei der Impedanzlernalgorithmus so eingerichtet ist, dass er auf der Basis mehrerer Veränderungen bei der bestimmten Spannung $\Delta V_a$, $\Delta V_b$, $\Delta V_c$ und dem bestimmten Strom $\Delta I_a$, $\Delta I_b$, $\Delta I_c$ bei jeder Phase des Stromverteilungsnetzes (1) eine Nullimpedanz $Z_0$ und eine Gegenimpedanz $Z_2$ des Stromverteilungsnetzes (1) bestimmt,

aufweist, **dadurch gekennzeichnet, dass** der Impedanzlernalgorithmus so eingerichtet ist, dass er durch Bestimmen von Korrelationsausdrücken $z_{20}$, $z_{02}$ einen Impedanzwert $Z_a$, $Z_b$, $Z_c$ für jede Phase (a, b, c) des Stromverteilungsnetzes (1) bestimmt, wobei der Korrelationsausdruck $z_{20}$ eine Korrelation zwischen einer Nullspannung $V_0$ und einem Gegenstrom $I_2$ angibt, und wobei der Korrelationsausdruck $z_{02}$ eine Korrelation zwischen einen Nullstrom $I_0$ und einer Gegenspannung $V_2$ angibt.

2. Stromzähler (7) nach Anspruch 1, wobei der Impedanzlernalgorithmus so eingerichtet ist, dass er für die Bestimmung der Nullimpedanz $Z_0$ und der Gegenimpedanz $Z_2$ wie auch der Korrelationsausdrücke $z_{20}$, $z_{02}$ nur jene Veränderun-

gen bei der bestimmten Spannung $\Delta V_a$, $\Delta V_b$, $\Delta V_c$ und dem bestimmten Strom $\Delta I_a$, $\Delta I_b$, $\Delta I_c$ einbezieht, bei denen die relative Veränderung bei dem Strom $\Delta I_a/I_a$, $\Delta I_b/I_b$, $\Delta I_c/I_c$ ein Faktor k > 1, vorzugsweise k » 1, ist, der größer als die relative Veränderung bei der Spannung $\Delta V_a/V_a$, $\Delta V_b/V_b$, $\Delta V_c/V_c$ ist.

3. Stromzähler (7) nach Anspruch 1 oder 2, wobei der Impedanzlernalgorithmus so eingerichtet ist, dass er die Korrelationsausdrücke $z_{20}$, $z_{02}$ wie folgt bestimmt,

$$z_{20} = -\frac{\Delta V_0}{\Delta I_2} - Z_0\frac{\Delta I_0}{\Delta I_2} = -\frac{\Delta V_a + \Delta V_b + \Delta V_c}{\Delta I_a + a^2\Delta I_b + a\Delta I_c} - Z_0\frac{\Delta I_a + \Delta I_b + \Delta I_c}{\Delta I_a + a^2\Delta I_b + a\Delta I_c},$$

$$z_{02} = -\frac{\Delta V_2}{\Delta I_0} - Z_2\frac{\Delta I_2}{\Delta I_0} = -\frac{\Delta V_a + a^2\Delta V_b + a\Delta V_c}{\Delta I_a + \Delta I_b + \Delta I_c} - Z_2\frac{\Delta I_a + a^2\Delta I_b + a\Delta I_c}{\Delta I_a + \Delta I_b + \Delta I_c},$$

wobei $a = e^{i\frac{2\pi}{3}}$ ein komplexer Operator ist, um eine Nennphasenverschiebung von 120 ° zwischen den Phasen (a, b, c) zu berücksichtigen.

4. Stromzähler (7) nach Anspruch 3, wobei der Impedanzlernalgorithmus so eingerichtet ist, dass er den Impedanzwert $Z_a$, $Z_b$, $Z_c$ für jede Phase (a, b, c) des Stromverteilungsnetzes (1) und einen Impedanzwert $Z_N$ für einen Nullleiter (N) des Stromverteilungsnetzes (1) einzeln wie folgt bestimmt:

$$Z_a = Z_2 + z_{20} + z_{02},$$

$$Z_b = Z_2 + a^2 z_{20} + a z_{02},$$

$$Z_c = Z_2 + a z_{20} + a^2 z_{02},$$

und

$$Z_N = \frac{1}{3}(Z_0 - Z_2).$$

5. Stromzähler (7) nach einem der vorhergehenden Ansprüche, wobei der Impedanzlernalgorithmus so eingerichtet ist, dass er die Veränderungen bei der bestimmten Spannung $\Delta V_a$, $\Delta V_b$, $\Delta V_c$ und dem bestimmten Strom $\Delta I_a$, $\Delta I_b$, $\Delta I_c$ auf der Basis der Spannung $V_a$, $V_b$, $V_c$ und des Stroms $I_a$, $I_b$, $I_c$, die zu unterschiedlichen Zeitpunkten $t_0$ und $†_1$ bestimmt werden, bestimmt, wobei der Unterschied zwischen $t_0$ und $t_1$ weniger als fünf Minuten beträgt.

6. Stromzähler (7) nach einem der vorhergehenden Ansprüche, wobei der Impedanzlernalgorithmus so eingerichtet ist, dass er den Impedanzwert $Z_a$, $Z_b$, $Z_c$ für jede Phase (a, b, c) des Stromverteilungsnetzes (1) und einen Impedanzwert $Z_N$ für einen Nullleiter (N) des Stromverteilungsnetzes (1) iterativ optimiert.

7. Stromzähler (7) nach einem der vorhergehenden Ansprüche, wobei der Impedanzlernalgorithmus so eingerichtet ist, dass er nach dem Bestimmen des Impedanzwerts $Z_a$, $Z_b$, $Z_c$ für jede Phase (a, b, c) und eines Impedanzwerts $Z_N$ für einen Nullleiter (N) des Stromverteilungsnetzes (1) eine akkumulierte Veränderung des Stroms $\Delta I_{a\Sigma}$, $\Delta I_{b\Sigma}$, $\Delta I_{c\Sigma}$, die eine akkumulierte Summe früher bestimmter Veränderungen bei dem Strom $\Delta I_a$, $\Delta I_b$, $\Delta I_c$ angibt, protokolliert.

8. Verfahren zum Bestimmen von Impedanzwerten in einem Drehstromversorgungsnetz (1), wobei das Verfahren

- ein Bestimmen (401) einer Spannung $V_a$, $V_b$, $V_c$ und eines Stroms $I_a$, $I_b$, $I_c$ bei jeder Phase des Stromverteilungsnetzes (1) mittels wenigstens eines Stromzählers (7) zum Bestimmen des Stromverbrauchs in einem Drehstromverteilungsnetz (1),
- ein Berechnen (403) des Stromverbrauchs von dem Stromverteilungsnetz (1) mittels des wenigstens einen Stromzählers (7), und

- ein Bestimmen (405) einer Nullimpedanz $Z_0$ und einer Gegenimpedanz $Z_2$ des Stromverteilungsnetzes durch den wenigstens einen Stromzähler (7) auf der Basis mehrerer Veränderungen bei der bestimmten Spannung $\Delta V_a$, $\Delta V_b$, $\Delta V_c$ und dem bestimmten Strom $\Delta I_a$, $\Delta I_b$, $\Delta I_c$ bei jeder Phase des Stromverteilungsnetzes (1)

umfasst, **dadurch gekennzeichnet, dass**

das Verfahren ferner ein Bestimmen (407) eines Impedanzwerts $Z_a$, $Z_b$, $Z_c$ für jede Phase (a, b, c) des Stromverteilungsnetzes (1) durch Bestimmen von Korrelationsausdrücken $z_{20}$, $z_{02}$ umfasst, wobei der Korrelationsausdruck $z_{20}$ eine Korrelation zwischen einer Nullspannung $V_0$ und einem Gegenstrom $I_2$ angibt, und wobei der Korrelationsausdruck $z_{02}$ eine Korrelation zwischen einen Nullstrom $I_0$ und einer Gegenspannung $V_2$ angibt.

9. Verfahren nach Anspruch 8, wobei für die Bestimmung der Nullimpedanz $Z_0$ und der Gegenimpedanz $Z_2$ wie auch der Korrelationsausdrücke $z_{20}$, $z_{02}$ nur jene Veränderungen bei der bestimmten Spannung $\Delta V_a$, $\Delta V_b$, $\Delta V_c$ und dem bestimmten Strom $\Delta I_a$, $\Delta I_b$, $\Delta I_c$ einbezogen werden, bei denen die relative Veränderung bei dem Strom $\Delta I_a/I_a$, $\Delta I_b/I_b$, $\Delta I_c/I_c$ ein Faktor k > 1 ist, der größer als die relative Veränderung bei der Spannung $\Delta V_a/V_a$, $\Delta V_b/V_b$, $\Delta V_c/V_c$ ist.

10. Verfahren nach Anspruch 8 oder 9, wobei die Korrelationsausdrücke $z_{20}$, $z_{02}$ wie folgt bestimmt werden,

$$z_{20} = -\frac{\Delta V_0}{\Delta I_2} - Z_0 \frac{\Delta I_0}{\Delta I_2} = -\frac{\Delta V_a + \Delta V_b + \Delta V_c}{\Delta I_a + a^2 \Delta I_b + a \Delta I_c} - Z_0 \frac{\Delta I_a + \Delta I_b + \Delta I_c}{\Delta I_a + a^2 \Delta I_b + a \Delta I_c},$$

$$z_{02} = -\frac{\Delta V_2}{\Delta I_0} - Z_2 \frac{\Delta I_2}{\Delta I_0} = -\frac{\Delta V_a + a^2 \Delta V_b + a \Delta V_c}{\Delta I_a + \Delta I_b + \Delta I_c} - Z_2 \frac{\Delta I_a + a^2 \Delta I_b + a \Delta I_c}{\Delta I_a + \Delta I_b + \Delta I_c},$$

wobei $a = e^{i\frac{2\pi}{3}}$ ein komplexer Operator ist, um eine Nennphasenverschiebung von 120 ° zwischen den Phasen zu berücksichtigen.

11. Verfahren nach Anspruch 10, wobei der Impedanzwert $Z_a$, $Z_b$, $Z_c$ für jede Phase (a, b, c) des Stromverteilungsnetzes (1) und ein Impedanzwert $Z_N$ für einen Nullleiter (N) des Stromverteilungsnetzes (1) einzeln wie folgt bestimmt werden:

$$Z_a = Z_2 + z_{20} + z_{02},$$

$$Z_b = Z_2 + a^2 z_{20} + a z_{02},$$

$$Z_c = Z_2 + a z_{20} + a^2 z_{02},$$

und

$$Z_N = \frac{1}{3}(Z_0 - Z_2).$$

12. Verfahren nach einem der Ansprüche 8 bis 11, wobei die Veränderungen bei der bestimmten Spannung $\Delta V_a$, $\Delta V_b$, $\Delta V_c$ und dem bestimmten Strom $\Delta I_a$, $\Delta I_b$, $\Delta I_c$ auf der Basis der Spannung $V_a$, $V_b$, $V_c$ und des Stroms $I_a$, $I_b$, $I_c$, die zu unterschiedlichen Zeitpunkten $t_0$ und $t_1$ bestimmt werden, bestimmt werden, wobei der Unterschied zwischen $t_0$ und $t_1$ weniger als fünf Minuten beträgt.

13. Verfahren nach einem der Ansprüche 8 bis 12, wobei für die Bestimmung der Nullimpedanz $Z_0$ und der Gegenimpedanz $Z_2$ wie auch der Korrelationsausdrücke $z_{20}$, $z_{02}$ nur jene Veränderungen bei der bestimmten Spannung $\Delta V_a$, $\Delta V_b$, $\Delta V_c$ und dem bestimmten Strom $\Delta I_a$, $\Delta I_b$, $\Delta I_c$ einbezogen werden, bei denen die bestimmte Spannung $V_a$, $V_b$, $V_c$ oder der bestimmte Strom $I_a$, $I_b$, $I_c$ über einem Mindestschwellenwert $V_{min}$, $I_{min}$ liegt.

**14.** Verfahren nach einem der Ansprüche 8 bis 13, wobei der bestimmte Impedanzwert $Z_a$, $Z_b$, $Z_c$ für jede Phase (a, b, c) des Stromverteilungsnetzes und ein Impedanzwert $Z_N$ für einen Nullleiter (N) des Stromverteilungsnetzes (1) iterativ optimiert werden.

**15.** System zum Bestimmen des Stromverbrauchs in einem Drehstromverteilungsnetz (1), wobei das System

- mehrere Stromzähler (7) nach einem der Ansprüche 1 bis 7, die an Stromverbraucherstellen in dem Drehstromverteilungsnetz (1) installiert sind, und
- ein Head-End-System (HES) in einer Signalverbindung mit den mehreren Stromzählern (7), um von den Verbraucherstellen automatisch Stromverbrauchsinformationen zu sammeln, wobei das Head-End-System (HES) so eingerichtet ist, dass es von den Stromzählern (7) einen Impedanzwert $Z_a$, $Z_b$, $Z_c$ für jede Phase (a, b, c) des Stromverteilungsnetzes (1) sammelt,

aufweist.

**16.** System nach Anspruch 15, wobei das Head-End-System (HES) ferner so eingerichtet ist, dass es von den Stromzählern (7) einen Impedanzwert $Z_N$ für einen Nullleiter (N) des Stromverteilungsnetzes (1) sammelt.


**Revendications**

**1.** Compteur électrique (7) pour déterminer la consommation d'électricité dans un réseau de distribution d'électricité triphasé (1), dans lequel le compteur électrique (7) comprend:

- un circuit (11) pour déterminer une tension $V_a$, $V_b$, $V_c$ et un courant $I_a$, $I_b$, $I_c$ à chaque phase (a, b, c) du réseau de distribution d'électricité (1),
- au moins un microcontrôleur (13) pour calculer la consommation d'électricité du réseau de distribution d'électricité (1), et
- un algorithme d'apprentissage d'impédance destiné à être exécuté par le ou les microcontrôleurs (13), dans lequel l'algorithme d'apprentissage d'impédance est configuré pour déterminer, sur la base d'une pluralité de changements de la tension $\Delta V_a$, $\Delta V_b$, $\Delta V_c$ et du courant $\Delta I_a$, $\Delta I_b$, $\Delta I_c$ déterminés à chaque phase du réseau de distribution d'électricité (1), une impédance homopolaire $Z_0$ et une impédance inverse $Z_2$ du réseau de distribution d'électricité (1),

**caractérisé en ce que**
l'algorithme d'apprentissage d'impédance est configuré pour déterminer une valeur d'impédance $Z_a$, $Z_b$, $Z_c$ pour chaque phase (a, b, c) du réseau de distribution d'électricité (1) en déterminant les termes de corrélation $z_{20}$, $z_{02}$, dans lequel le terme de corrélation $z_{20}$ indique une corrélation entre une tension homopolaire $V_0$ et un courant inverse $I_2$ et dans lequel le terme de corrélation indique une corrélation entre un courant homopolaire $I_0$ et une tension inverse $V_2$.

**2.** Compteur électrique (7) selon la revendication 1, dans lequel l'algorithme d'apprentissage d'impédance est configuré pour inclure, pour la détermination de l'impédance homopolaire $Z_0$ et de l'impédance inverse $Z_2$ ainsi que des termes de corrélation $z_{20}$, $z_{02}$, uniquement les variations déterminées de la tension $\Delta V_a$, $\Delta V_b$, $\Delta V_c$ et du courant $\Delta I_a$, $\Delta I_b$, $\Delta I_c$ pour lesquelles la variation relative du courant $\Delta I_a/I_a$, $\Delta I_b/I_b$, $\Delta I_c/I_c$ est un facteur k>1, de préférence k>>1, supérieur à la variation relative de la tension $\Delta V_a/V_a$, $\Delta V_b/V_b$, $\Delta V_c/V_c$.

**3.** Compteur électrique (7) selon la revendication 1 ou 2, dans lequel l'algorithme d'apprentissage d'impédance est configuré pour déterminer les termes de corrélation $z_{20}$, $Z_{02}$ comme suit:

$$z_{20} = -\frac{\Delta V_0}{\Delta I_2} - Z_0\frac{\Delta I_0}{\Delta I_2} = -\frac{\Delta V_a + \Delta V_b + \Delta V_c}{\Delta I_a + a^2\Delta I_b + a\Delta I_c} - Z_0\frac{\Delta I_a + \Delta I_b + \Delta I_c}{\Delta I_a + a^2\Delta I_b + a\Delta I_c},$$

$$z_{02} = -\frac{\Delta V_2}{\Delta I_0} - Z_2\frac{\Delta I_2}{\Delta I_0} = -\frac{\Delta V_a + a^2\Delta V_b + a\Delta V_c}{\Delta I_a + \Delta I_b + \Delta I_c} - Z_2\frac{\Delta I_a + a^2\Delta I_b + a\Delta I_c}{\Delta I_a + \Delta I_b + \Delta I_c},$$

dans lequel $a = e^{i\frac{2\pi}{3}}$ est un opérateur complexe pour tenir compte d'un déphasage nominal de 120 entre les phases (a, b, c).

4. Compteur électrique (7) selon la revendication 3, dans lequel l'algorithme d'apprentissage d'impédance est configuré pour déterminer individuellement la valeur d'impédance $Z_a$, $Z_b$, $Z_c$ pour chaque phase (a, b, c) du réseau de distribution d'électricité (1) et une valeur d'impédance $Z_N$ pour un fil neutre (N) du réseau de distribution d'électricité (1) comme suit :

$$Z_a = Z_2 + z_{20} + z_{02},$$

$$Z_b = Z_2 + a^2 z_{20} + a z_{02},$$

$$Z_c = Z_2 + a z_{20} + a^2 z_{02},$$

et

$$Z_N = \frac{1}{3}(Z_0 - Z_2).$$

5. Compteur électrique (7) selon une quelconque des revendications précédentes, dans lequel l'algorithme d'apprentissage d'impédance est configuré pour déterminer les variations de la tension déterminée $\Delta V_a$, $\Delta V_b$, $\Delta V_c$ et du courant déterminé $\Delta I_a$, $\Delta I_b$, $\Delta I_c$ sur la base de la tension $V_a$, $V_b$, $V_c$ et du courant $I_a$, $I_b$, $I_c$ déterminés à différents moments dans le temps $t_0$ et $t_1$, dans lequel la différence entre $t_0$ et $t_1$ est inférieure à cinq minutes.

6. Compteur électrique (7) selon une quelconque des revendications précédentes, dans lequel l'algorithme d'apprentissage d'impédance est configuré pour optimiser de manière itérative la valeur d'impédance $Z_a$, $Z_b$, $Z_c$ pour chaque phase (a, b, c) du réseau de distribution d'électricité (1) et une valeur d'impédance $Z_N$ pour un fil neutre (N) du réseau de distribution d'électricité (1).

7. Compteur électrique (7) selon une quelconque des revendications précédentes, dans lequel l'algorithme d'apprentissage d'impédance est configuré pour enregistrer, après avoir déterminé la valeur d'impédance $Z_a$, $Z_b$, $Z_c$ pour chaque phase (a, b, c) et une valeur d'impédance $Z_N$ pour un fil neutre (N) du réseau de distribution d'électricité (1), une variation accumulée du courant $\Delta I_{a\Sigma}$, $\Delta I_{b\Sigma}$, $\Delta I_{c\Sigma}$, indiquant une somme accumulée de variations précédemment déterminées du courant $\Delta I_a$, $\Delta I_b$, $\Delta I_c$.

8. Procédé de détermination des valeurs d'impédance dans un réseau de distribution d'électricité triphasé (1), le procédé comprenant:

- la détermination (401) d'une tension $V_a$, $V_b$, $V_c$ et d'un courant $I_a$, $I_b$, $I_c$ à chaque phase du réseau de distribution d'électricité (1) au moyen d'au moins un compteur électrique (7) pour déterminer la consommation d'électricité dans un réseau de distribution d'électricité triphasé (1),
- le calcul (403) de la consommation d'électricité du réseau de distribution d'électricité (1) au moyen dudit au moins un compteur électrique (7) et
- la détermination (405) par ledit au moins un compteur électrique (7), sur la base d'une pluralité de variations de la tension $\Delta V_a$, $\Delta V_b$, $\Delta V_c$ et du courant $\Delta I_a$, $\Delta I_b$, $\Delta I_c$ déterminés à chaque phase du réseau de distribution d'électricité (1), d'une impédance homopolaire $Z_0$ et d'une impédance inverse $Z_2$ du réseau de distribution d'électricité,

**caractérisé en ce que**
le procédé comprend en outre la détermination (407) d'une valeur d'impédance $Z_a$, $Z_b$, $Z_c$ pour chaque phase (a,b,c) du réseau de distribution d'électricité (1) en déterminant les termes de corrélation $z_{20}$, $z_{02}$, dans lequel le terme de corrélation $z_{20}$ indique une corrélation entre une tension homopolaire $V_0$ et un courant inverse $I_2$, et dans lequel le terme de corrélation indique une corrélation entre un courant homopolaire $I_0$ et une tension inverse $V_2$.

9. Procédé selon la revendication 8, dans lequel uniquement les variations déterminées de la tension $\Delta V_a$, $\Delta V_b$, $\Delta V_c$ et du

courant $\Delta I_a$, $\Delta I_b$, $\Delta I_c$ pour lesquelles la variation relative du courant $\Delta I_a/I_a$, $\Delta I_b/I_b$, $\Delta I_c/Ic$ est un facteur k>1 plus grand que la variation relative de la tension $\Delta V_a/V_a$, $\Delta V_b/V_b$, $\Delta V_c/V_c$ sont prises en compte pour la détermination de l'impédance homopolaire $Z_0$ et de l'impédance inverse $Z_2$ ainsi que les termes de corrélation $z_{20}$, $z_{02}$.

10. Procédé selon la revendication 8 ou 9, dans lequel les termes de corrélation $z_{20}$, $z_{02}$ sont déterminés comme suit:

$$z_{20} = -\frac{\Delta V_0}{\Delta I_2} - Z_0\frac{\Delta I_0}{\Delta I_2} = -\frac{\Delta V_a + \Delta V_b + \Delta V_c}{\Delta I_a + a^2\Delta I_b + a\Delta I_c} - Z_0\frac{\Delta I_a + \Delta I_b + \Delta I_c}{\Delta I_a + a^2\Delta I_b + a\Delta I_c},$$

$$z_{02} = -\frac{\Delta V_2}{\Delta I_0} - Z_2\frac{\Delta I_2}{\Delta I_0} = -\frac{\Delta V_a + a^2\Delta V_b + a\Delta V_c}{\Delta I_a + \Delta I_b + \Delta I_c} - Z_2\frac{\Delta I_a + a^2\Delta I_b + a\Delta I_c}{\Delta I_a + \Delta I_b + \Delta I_c},$$

dans lequel $a = e^{i\frac{2\pi}{3}}$ est un opérateur complexe pour tenir compte d'un déphasage nominal de 120 entre les phases.

11. Procédé selon la revendication 10, dans lequel la valeur d'impédance $Z_a$, $Z_b$, $Z_c$ pour chaque phase (a, b, c) du réseau de distribution d'électricité (1) et une valeur d'impédance $Z_N$ pour un fil neutre (N) du réseau de distribution d'électricité (1) sont déterminées individuellement comme suit :

$$Z_a = Z_2 + z_{20} + z_{02},$$

$$Z_b = Z_2 + a^2 z_{20} + a z_{02},$$

$$Z_c = Z_2 + a z_{20} + a^2 z_{02},$$

et

$$Z_N = \frac{1}{3}(Z_0 - Z_2).$$

12. Procédé selon une quelconque des revendications 8 à 11, dans lequel les variations de la tension déterminée $\Delta V_a$, $\Delta V_b$, $\Delta V_c$ et du courant déterminé $\Delta I_a$, $\Delta I_b$, $\Delta I_c$ sont déterminées sur la base de la tension $V_a$, $V_b$, $V_c$ et du courant $I_a$, $I_b$, $I_c$ déterminés à différents moments dans le temps $t_0$ et $t_1$, dans lequel la différence entre $t_0$ et $t_1$ est inférieure à cinq minutes.

13. Procédé selon une quelconque des revendications 8 à 12, dans lequel uniquement les variations de la tension déterminée $\Delta V_a$, $\Delta V_b$, $\Delta V_c$ et du courant déterminé $\Delta I_a$, $\Delta I_b$, $\Delta I_c$ pour lesquelles la tension déterminée $V_a$, $V_b$, $V_c$ ou le courant déterminé $I_a$, $I_b$, $I_c$ est supérieur à un seuil minimal $V_{min}$, $I_{min}$ sont prises en compte pour la détermination de l'impédance homopolaire $Z_0$ et de l'impédance inverse $Z_2$ ainsi que les termes de corrélation $z_{20}$, $z_{02}$.

14. Procédé selon une quelconque des revendications 8 à 13, dans lequel la valeur d'impédance déterminée $Z_a$, $Z_b$, $Z_c$ pour chaque phase (a, b, c) du réseau de distribution d'électricité et une valeur d'impédance $Z_N$ pour un fil neutre (N) du réseau de distribution d'électricité (1) sont optimisées de manière itérative.

15. Système de détermination de la consommation d'électricité dans un réseau de distribution d'électricité triphasé (1), dans lequel le système comprend:

- une pluralité de compteurs électriques (7) selon une quelconque des revendications 1 à 7 installés sur des sites consommateurs d'électricité dans le réseau de distribution d'électricité triphasé (1) et
- un système de tête de réseau (HES) en connexion de signal avec la pluralité de compteurs électriques (7) pour collecter automatiquement des informations de consommation d'électricité à partir des sites consommateurs, dans lequel le système de tête de réseau (HES) est configuré pour collecter à partir des compteurs électriques (7) une valeur d'impédance $Z_a$, $Z_b$, $Z_c$ pour chaque phase (a, b, c) du réseau de distribution d'électricité (1).

16. Système selon la revendication 15, dans lequel le système de tête de réseau (HES) est en outre configuré pour collecter à partir des compteurs électriques (7) une valeur d'impédance $Z_N$ pour un fil neutre (N) du réseau de distribution d'électricité (1).

Fig. 1

Positive sequence components

$$V_{b1} = a^2 V_{a1}$$
$$V_{c1} = a V_{a1}$$

(denoted by subscript 1)

Negative sequence components

$$V_{b2} = a V_{a2}$$
$$V_{c2} = a^2 V_{a2}$$

(denoted by subscript 2)

Zero sequence components

$$V_{b0} = V_{a0}$$
$$= V_{c0}$$

(denoted by subscript 0)

Fig. 2

EP 4 290 247 B1

305

301

303

307

309

Initialize

Algorithm

Running

Logger

Adaptive

Update F_FACTOR

311

Auto-reset?

no

yes

Fig. 3

Fig. 4

| Name | Algorithm ref. | Interval | Resolution | Unit |
|---|---|---|---|---|
| Time stamp | | | | Time |
| Number of runs | nRun | 0,...,+32 bit | 1 | Number |
| Accumulated learning L1 | $\Delta I_{a\,\Sigma}$ | 0,...,+16 bit | 1 | Ampere (A) |
| Accumulated learning L2 | $\Delta I_{b\,\Sigma}$ | 0,...,+16 bit | 1 | Ampere (A) |
| Accumulated learning L3 | $\Delta I_{c\,\Sigma}$ | 0,...,+16 bit | 1 | Ampere (A) |
| Forgetting factor | F_FACTOR | 0,...,+16 bit | 1 | |
| Zero sequence resistance | $R_0$ | -10,...,+10 | 0.001 | Ohm ($\Omega$) |
| Zero sequence reactance | $X_0$ | -10,...,+10 | 0.001 | Ohm ($\Omega$) |
| Negative sequence resistance | $R_2$ | -10,...,+10 | 0.001 | Ohm ($\Omega$) |
| Negative sequence reactance | $X_2$ | -10,...,+10 | 0.001 | Ohm ($\Omega$) |
| Neutral wire resistance | $R_N$ | -10,...,+10 | 0.001 | Ohm ($\Omega$) |
| Neutral wire reactance | $X_N$ | -10,...,+10 | 0.001 | Ohm ($\Omega$) |
| Phase L1 resistance | $R_a$ | -10,...,+10 | 0.001 | Ohm ($\Omega$) |
| Phase L1 reactance | $X_a$ | -10,...,+10 | 0.001 | Ohm ($\Omega$) |
| Phase L2 resistance | $R_b$ | -10,...,+10 | 0.001 | Ohm ($\Omega$) |
| Phase L2 reactance | $X_b$ | -10,...,+10 | 0.001 | Ohm ($\Omega$) |
| Phase L3 resistance | $R_c$ | -10,...,+10 | 0.001 | Ohm ($\Omega$) |
| Phase L3 reactance | $X_c$ | -10,...,+10 | 0.001 | Ohm ($\Omega$) |

# Fig. 5a

| Name | Algorithm ref. | Interval | Resolution | Unit |
|---|---|---|---|---|
| Forgetting factor | F_FACTOR | 0,...,+16 bit | 1 | |
| Adaptive factor | F_ADAPTIVE | 0,...,255 | 1 | |
| Auto-reset | | T/F | Bool | |
| Enable MILA | | T/F | Bool | |

# Fig. 5b

Fig. 6a

Fig. 6b

Fig. 6c

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2018122160 A1